Europäisches Patentamt

**European Patent Office**

**Office européen des brevets**

(19)

(11) Veröffentlichungsnummer : **0 081 493**
**B1**

(12) **EUROPÄISCHE PATENTSCHRIFT**

(45) Veröffentlichungstag der Patentschrift :
**16.04.86**

(21) Anmeldenummer : **82900302.9**

(22) Anmeldetag : **14.01.82**

(86) Internationale Anmeldenummer :
**PCT/DE 82/00010**

(87) Internationale Veröffentlichungsnummer :
**WO/8202431 (22.07.82 Gazette 82/18)**

(51) Int. Cl.⁴ : **G 01 R 13/22**

(54) **VERFAHREN UND ANORDNUNG ZUM VERTIKALEN ODER HORIZONTALEN DARSTELLEN EINES ODER MEHRERER MESSWERTE BELIEBIGER MESSGRÖSSEN AUF EINEM BILDSCHIRM.**

(30) Priorität : **15.01.81 DE 3100986**

(43) Veröffentlichungstag der Anmeldung :
**22.06.83 Patentblatt 83/25**

(45) Bekanntmachung des Hinweises auf die Patenterteilung : **16.04.86 Patentblatt 86/16**

(84) Benannte Vertragsstaaten :
**AT BE CH DE FR GB LI LU NL SE**

(56) Entgegenhaltungen :
**DE-A- 2 544 489**
**DE-A- 2 653 391**
**DE-A- 2 728 457**
**DE-B- 1 416 594**
**DE-B- 1 808 245**
**DE-B- 2 149 636**
**DE-B- 2 638 858**
**GB-A- 1 136 506**
**US-A- 3 739 222**
**US-A- 3 786 476**

(73) Patentinhaber : **HERWEG, Arnulf**
**Grillenweg 44**
**D-8501 Feucht (DE)**

(72) Erfinder : **HERWEG, Arnulf**
**Grillenweg 44**
**D-8501 Feucht (DE)**

(74) Vertreter : **Schweinzer, Karl, Dr. Dipl.-Phys.**
**Essenweinstrasse 4-6**
**D-8500 Nürnberg 70 (DE)**

**Beschreibung**

Die Erfindung betrifft ein Verfahren und eine Anordnung zum vertikalen oder horizontalen Darstellen eines oder mehrerer Meßwerte beliebiger Meßgrößen auf dem Bildschirm eines nach dem Zeilenrasterverfahren arbeitenden Sichtgerätes, insbesondere eines Farbbildschirmgerätes, bei dem in einem Synchronimpulsgenerator Zeilen- und Bildfrequenzimpulse erzeugt werden.

Ein derartiges Verfahren bzw. eine derartige Anordnung ist in der DE-A1-2 544 489 beschrieben.

Bei einer anderen bekannten Anordnung werden vor Beginn der Darstellung der einzelnen Meß- oder Kurvenpunkte mit der Zeile die in dieser Zeile darzustellenden Meßwerte in ein Ausgaberegister eines Bildwiederholungsspeichers gegeben. Während der Elektronenstrahl über den Bildschirm läuft, wird ein Rasterzähler mit Taktimpulsen hochgezählt bis dieser den im Ausgaberegister enthaltenen Meßwert erreicht. Sodann wird ein Bildpunkt auf dem Schirm erzeugt. In jeder Zeile kann nur ein Meßwert dargestellt werden (DE-A-1 808 245).

Ausgehend von dieser Anordnung ist ein Verfahren bekannt, mit dem Meßwertkurven dargestellt werden können, deren Ordinatenrichtung senkrecht zur Zeilenrichtung und deren Abszisse in Zeilenrichtung verläuft. Dazu werden die Meßwerte aus dem Bildwiederholungsspeicher beim Abtasten jeder Zeile in der Reihenfolge ausgegeben, in der sie, bezogen auf die Zeilenrichtung, dargestellt werden, wobei der Meßwert, der, bezogen auf die Zeilenrichtung, am nächsten vom Bildfeldrand dargestellt werden soll, nach jedem Zeilenrücklauf als erster ausgegeben wird, und die Meßwerte in einem solchen Zeilenabstand ausgegeben werden, daß der Elektronenstrahl von der Ausgabe des einen Meßwertes bis zur Ausgabe des nächsten auf dem Bildschirm einen Weg zurücklegt, der gleich dem kleinsten Abstand vom Bildpunkt in Zeilenrichtung ist und die ausgegebenen Meßwerte mit dem negierten Stand eines Zeilenzählers oder der negierte ausgegebene Meßwert mit dem Stand des Zeilenzählers verglichen und bei Gleichheit ein Signal abgegeben Wird (DE-B-2 149 636). Eine wahlweise Darstellung einer Kurve von unten nach oben oder von links nach rechts ist nicht möglich. Zwar wäre es prinzipiell möglich, die Ablenkspule des Sichtgerätes um 90° zu drehen, jedoch sind dann handelsübliche Sichtgeräte nicht brauchbar. Es besteht oft das Bedürfnis, eine größere Zahl von Meßwerten gleichzeitig und übersichtlich dazustellen, wobei gegebenenfalls noch Grenzwerte und/oder Ist- bzw. Sollwerte dargestellt werden sollen.

Der Erfindung liegt daher die Aufgabe zugrunde, ein Verfahren und eine Anordnung der eingangs erläuterten Art derart auszubilden, daß ein oder mehrere Meßwerte wählbar in einfacher Weise horizontal oder vertikal, auch von oben nach unten bzw. von rechts nach links, bezogen auf den Bildschirm, dargestellt werden können, wobei insbesondere bei Verwendung eines Farbbildschirmgerätes die jeweiligen Meßwerte in unterschiedlichen Farben angezeigt werden, je nachdem ob sie einen Grenzwert überschreiten, wobei das Verfahren eine leichte Anpaßbarkeit an die jeweils gegebene Meßaufgaben sowie eine Meßwertspeicherung ermöglichen soll.

Diese Aufgabe wird nach der Erfindung bei einem Verfahren der eingangs erläuterten Art dadurch gelöst, daß eine jeder Meßgröße entsprechende Meßspannung gebildet und in einem Meßspannungsverstärker zunächst normiert und dann einem Addierverstärker zugeführt wird, dem gleichzeitig eine sägezahnartig verlaufende Spannung zugeführt wird, daß die sägezahnartige Spannung von den Bild- oder Zeilenfrequenzimpulsen oder einer den Bild- bzw. Zeilenfrequenzimpulsen entsprechenden Frequenz synchronisiert wird und die Ausgangsspannung des Addierverstärkers einem Schwellwertschalter zugeführt wird, der bei Überschreiten des Schwellwertes durch die Summenspannung ein der Meßspannung zeitproportionales Signal abgibt, wobei für die Meßwertabbildung auf dem Bildschirm von unten nach oben bei vertikaler Darstellung bzw. von rechts nach links bei horizontaler Darstellung eine Sägezahnspannung mit ansteigender Flanke oder für die Abbildung von oben nach unten bei vertikaler Darstellung bzw. von links nach rechts bei horizontaler Darstellung eine Sägezahnspannung mit abfallender Flanke benutzt wird, daß das der Meßspannung proportionales Signal einer nachfolgenden, mit den Zeilen- bzw. Bildfrequenzimpulsen synchronisierten Torschaltung zugeleitet und nach Pegelanpassung und Synchronimpulsmischung als Videosignal (BAS-Signal) dem Sichtgerät zugeleitet wird.

Dadurch, daß die sägezahnartige Spannung entweder von den Bildfrequenzimpulsen oder wahlweise von den Zeilenfrequenzimpulsen synchronisiert wird, ergibt sich eine senkrechte oder waagerechte Darstellung des oder der Meßwerte auf dem Bildschirm. Werden Sägezahnimpulse mit steigender Flanke verwendet, dann erfolgt die Anzeige des Meßwertes von unten nach oben, während bei Sägezahnimpulsen mit fallender Flanke die Anzeige auf dem Bildschirm von cben nach unten erfolgt. Dasselbe gilt in analoger Weise für die waagerechte Darstellung des Meßwertes. Durch diese erfindungsgemäße Erzeugung eines zeitproportionalen Signales werden aufwendige Zählereinrichtungen oder Multiplexerschaltungen vermieden.

In weiterer Ausgestaltung der Erfindung ist es zur Anzeige von Grenzwerten vorteilhaft, wenn der Torschaltung zusätzlich ein Grenzwertsignal zugeführt wird, das durch Zufuhr einer einstellbaren festen Spannung an einen Addierverstärker, dem andererseits eine sägezahnartige Spannung zugeführt wird, die vom Bild- bzw. Zeilensynchronimpuls synchronisiert ist, und analog der Meßsignalerzeugung durch einen Schwellwertschalter ein dem Grenzwert zeitproportionales Grenzwertsignal erzeugt.

Eine schaltungstechnische Vereinfachung ergibt sich dann, wenn, nach einer weiteren Ausgestaltung der Erfindung, die sägezahnartige Spannung für die Bildung des Meßwertsignales und die Bildung des Grenzwertes durch einen gemeinsamen Sägezahngenerator gebildet wird.

In noch weiterer Ausgestaltung der Erfindung wird zur Abbildung einer Grenzwertmarke auf dem Bildschirm des Sichtgerätes bei fehlender Meßspannung oder einer Meßspannung kleiner als der Grenzwert ein der Grenzwertmarke zeitproportionales Grenzwertmarkensignal erzeugt und dem Meßwertsignal und der Torschaltung zugeführt.

Um besondere Ereignisse zu speichern, ist es vorteilhaft, wenn bei Überschreiten eines vorgegebenen Grenzwertes durch das Meßsignal ein Grenzwertspeicher aktiviert wird.

Die Ausbildung soll dabei derart getroffen werden, daß der Grenzwertspeicher durch einen Rücksetzimpuls wahlweise oder selbsttätig gelöscht wird.

Bei Verwendung eines Farbbildschirmgerätes ist es in weiterer Gestaltung der Erfindung vorteilhaft, daß die die Torschaltung passierenden Impulse einer Auswahlschaltung zugeführt werden, die den Farbkanälen eines Farbbildgerätes zugehörende R-, G-, B-Ausgänge aufweist und an die dem Grenzwert bzw. Meßwert entsprechenden Ausgänge Ausgangssignale in Abhängigkeit von der Größe des Grenzwertes und-/oder des Meßwertes abgibt und die R-, G-, B-Signale dem Sichtgerät direkt oder bei entsprechender Umwandlung als F-BAS-Signale und/oder über eine HF-Stufe als normiertes HF-Farbsignal zugeleitet werden.

In weiterer Ausgestaltung ist es vorteilhaft, daß zur gleichzeitigen Darstellung mehrerer Grenzwerte und/oder Meßwerte jedem Meßwert ein Meßwertkanal und diesem eine Torschaltung zugeordnet ist, daß der Torschaltung eines ersten Meßwertkanales ein in einer Torzeitstufe mittels Monoflop und/oder Flipflop gebildeter bild- oder zeilensynchroner Torzeitimpuls zugeleitet wird, und daß die den einzelnen Meßsignales zugeordneten Torzeitimpulse zeitlich nacheinander der jeweils nachfolgenden Torzeitstufe des nächsten Meßkanales zugeführt werden.

Um ein bestimmtes Bildfeld auf dem Bildschirm zur Darstellung der Meßwerte auszunutzen, ist es vorteilhaft, wenn die Gesamtzeit eines bzw. aller Torzeitimpulse gleich oder kleiner ist als die Zeitdauer einer Zeile auf dem Bildschirm des Sichtgerätes.

Bei waagerechter Darstellung ist es vorteilhaft, wenn die Gesamtzeit eines bzw. aller Torzeitimpulse gleich oder kleiner ist als die Zeitdauer eines Bildes auf dem Sichtgerät.

Die Erfindung betrifft auch eine Anordnung zum vertikalen oder horizontalen Darstellen eines oder mehrerer Meßwerte beliebiger Meßgrößen auf dem Bildschirm eines nach dem Zeilenrasterverfahren arbeitenden Sichtgerätes, insbesondere eines Farbbildschirmgerätes, bei dem in einem Synchronimpulsgenerator Zeilen- und Bildfrequenzimpulse erzeugt werden, insbesondere zum Durchführen eines der Verfahren nach den Ansprüchen 1 bis 10, mit einem Netzteil und einem Synchronimpulsgenerator. Die erfindungsgemäße Anordnung ist gekennzeichnet durch eine den Synchronimpulsgenerator, eine Videopegelanpassungsstufe und eine Synchronmischstufe enthaltende Grundeinheit und mindestens eine Meßkanaleinheit, in der ein eine Meßspannung normierender Meßspannungsverstärker angeordnet ist, sowie ein Addierverstärker, dem einerseits die Meßspannung und andererseits eine von einem Sägezahngenerator erzeugte sägezahnartige Spannung über einen Entkopplungsverstärker zugeführt werden, wobei für die Meßwertabbildung auf dem Bildschirm von unten nach oben bei vertikaler Darstellung bzw. von rechts nach links bei horizontaler Darstellung eine Sägezahnspannung mit ansteigender Flanke oder für die Abbildung von oben nach unten bei vertikaler Darstellung bzw. von links nach rechts bei horizontaler Darstellung eine Sägezahnspannung mit abfallender Flanke benutzt wird, ferner ein Schwellwertschalter, dem die Summenspannung des Addierverstärkers zugeführt wird, und eine ein Ausgangssignal des Schwellwertschalters mit dem Zeilen- oder Bildfrequenzimpuls synchronisierten Torschaltung, die an eine Videopegelanpassungsstufe ein dem Meßwert proportionales Meßwertsignal liefert, aus dem in der folgenden Synchronimpulsmischstufe ein Videosignal gebildet wird.

Die erfindungsgemäße Anordnung ermöglicht es, unter Verwendung einer gegebenen Grundeinheit und eines gegebenen Bildschirmgerätes wahlweise eine Anzahl von Meßkanaleinheiten, je nach Bedarf anzuschließen, so daß eine große Anpassungsfähigkeit an die jeweils gestellte Meßaufgabe gegeben ist.

In bevorzugter Weise ist die Torschaltung ein UND-Gatter, ein NAND-Gatter oder eine 3-state Schaltung.

In weiterer Ausgestaltung der erfindungsgemäßen Anordnung kann ein Grenzwertgeber vorgesehen werden, dem von einer einstellbaren Festspannungsquelle über einen ersten Verstärker eine Grenzwertspannung zugeführt wird und der einen Addierverstärker zur Bildung einer Summenspannung aus der Grenzwertspannung und einer sägezahnartigen, von einem Sägezahngenerator erzeugten Spannung enthält, wobei dem Addierverstärker ein Schwellwertschalter nachgeschaltet ist, dessen Ausgang mit der Torschaltung verbunden ist.

Besonders zweckmäßig ist es, wenn in jeder Meßkanaleinheit mindestens ein Grenzwertgeber vorgesehen ist.

Zur Speicherung von Meßwerten oder bei Überschreitung eines Grenzwertes durch die Meßspannung ist es vorteilhaft, eine Flip-Flop-Schaltung vorzusehen, die durch einen Synchronimpuls gesetzt und nach der Zeit zurückgesetzt wird, zur Erzeugung eines meßwertproportionalen, im gesetzten Zustand von der Meßspannung unabhängigen Meßsignales.

Gemäß einer Abwandlung dieser Schaltstufe ist es vorteilhaft, eine von Synchronimpulsen gestartete Monoflopstufe vorzusehen, wobei der zeitbestimmende Widerstand des RC-Gliedes eine von der Meßspannung gesteuerte Konstantstromquelle ist.

Zur Erzeugung eines Meßsignales und eines Grenzwertsignales ist es vorteilhaft, wenn der Widerstand des RC-Gliedes des Monoflops als willkürlich oder vom Meßwert verstellbares Potentiometer ausgebildet ist.

Eine Vereinfachung der Schaltungsanordnung ergibt sich dann, wenn allen Grenzwertgebern und allen Meßwertgebern ein gemeinsamer Sägezahngenerator zugeordnet ist und in jeder Grenzwertgeberstufe und jeder Meßwertstufe ein Entkopplungsverstärker vorgesehen ist. In vorteilhafter Weise ist der Entkopplungsverstärker auch zur Linearisierung von nichtlinearen Meßwerten geeignet.

Da im allgemeinen jeder Meßkanal den anzuzeigenden Meßwert in Form eines Balkens auf dem Sichtgerät darstellt, ist es zur Unterscheidung der Meßwerte vorteilhaft, wenn der Sägezahngenerator als Treppengenerator ausgebildet ist.

In vorteilhafter Weiterbildung ist in jedem Meßkanal mit Grenzwertgeber ein Grenzwertmarkengeber mit dem Grenzwertgeber und der Torschaltung zweckmäßig über ein ODER- bzw. Dioden-Gatter verkoppelt, um Fehlfunktionen nachfolgender Schaltungen zu vermeiden. Zur farblichen Unterscheidung der Meßwerte je nach ihrer Größe auf dem Bildschirm eines Farbbildsichtgerätes ist es vorteilhaft, wenn der oder den Torschaltungen eine Auswahlschaltung mit NAND-Gattern und Inverterstufen nachgeschaltet ist.

Um Überschreitungen der einstellbaren Grenzwerte durch den jeweiligen Meßwert dauerhaft feststellen zu können, ist es vorteilhaft, wenn jedem Grenzwertgeber ein Grenzwertspeicher zugeordnet ist.

In vorteilhafter Weise sind die Grenzwertspeicher als Flip-Flop-Schaltung ausgebildet, die bei Erreichen oder Überschreiten des Grenzwertes durch den Meßwert gesetzt und wahlweise einzeln von Hand oder impulsgesteuert zurückgesetzt werden. Zur wahlweisen Einstellung der Breite der balkenartigen Darstellung der Meßwerte ist es vorteilhaft, wenn eine Torzeitstufe zur zeitlichen Begrenzung der Darstellung des Meßwertes und der Grenzwerte auf dem Bildschirm eines angeschlossenen Bildschirmes auf einen Teil eines Zeilenablaufes vorgesehen ist, wobei die Torzeitstufe einen vom Zeilenimpuls gestarten Monoflop aufweist, dessen Laufzeit ≤ der Zeilendauer ist.

In vorteilhafter Weise ist zur gemeinsamen Darstellung mehrerer Meßwerte auf dem Bildschirm des Sichtgerätes je Meßwert eine Meßkanaleinheit vorgesehen, mit einer Torzeitstufe, die die jeweilige Torschaltung steuert und nach Ablauf der Torzeit einen Startimpuls an die nachfolgende Meßkanaleinheit abgibt.

Zur Schaltungsvereinfachung ist es vorteilhaft, wenn eine Torzeitzentrale vorgesehen ist, die beispielweise in einer Grundeinheit angeordnet ist, und wenn die Torzeitstufe eines ersten Meßkanals von dieser Torzeitzentrale gestartet wird und nach Ablauf ihrer Torzeit einen Startimpuls an die Torzeitstufe des nachfolgenden Meßkanals und an die Torzeitzentrale abgibt.

Eine schaltungstechnisch vorteilhafte Vereinfachung ergibt sich dann, wenn nach weiterer Ausgestaltung der Erfindung, die Grundeinheit und die Meßkanaleinheiten einerseits über einen DatenBUS, dem von den Meßkanaleinheiten die Meßwerte, Grenzwerte, Grenzwertimpulse und dergleichen zugeführt und von diesen an die Grundeinheit geleitet werden, und andererseits über einen SteuerBUS verbunden sind, dem von der Grundeinheit die Synchronimpulse, gegebenenfalls die Sägezahnspannung und die Torzeitimpulse, zur Abgabe an die Meßwertkanäle zugeführt werden.

Bei Verwendung eines Farbbildschirmsichtgerätes ist es vorteilhaft, wenn die vom DatenBUS an die Auswahlschaltung abgegebenen Meßwerte, Grenzwerte und dergleichen nach der Auswahlschaltung als R-, G- und B-Signale abgegeben und danach in normierte R-, G- und B-Signale und auch in ein F-BAS-Signal umgewandelt werden. Diese Signale können auch auf einem Video-Recorder gespeichert werden.

Bei Verwendung einer Auswahlschaltung erfahren die Meßwerte, Grenzwerte und dergleichen eine gleichzeitige und bestimmte Zuordnung.

Da die Meßwerte, Grenzwerte und dergleichen nach der Auswahlschaltung eine gemeinsame und gleichzeitige Zuordnung erfahren, können diese Werte vor und nach der Auswahlschaltung in einer noch weiteren Ausgestaltung der Erfindung einer Datenschnittstelle zugeführt werden, zur weiteren Verarbeitung in einem Datenspeicher oder einer Datenverarbeitungseinheit.

Zur Erzeugung von festen und variablen Skalierungslinien auf dem Bildschirm ist es vorteilhaft, diese Linien ebenso wie die Grenzwertmarken zu erzeugen. Zur Erzeugung dieser Linien können auch an sich bekannte Schaltstufen angewendet werden. Ferner kann ein wahlweise betätigbarer Schriftgenerator vorgesehen sein.

Insbesondere ist es vorteilhaft, wenn zusätzlich eine Schaltungseinheit zur wahlweisen Einblendung von Uhrzeit und/oder Datum auf dem Bildschirm des Sichtgerätes oder zur Speicherung zusammen mit den Meßwertsignalen und dergleichen auf einem Videoband oder einem anderen Speicher vorgesehen ist.

Weitere Einzelheiten, Vorteile und Merkmale des erfindungsgemäßen Verfahrens und der erfindungsgemäßen Anordnung ergeben sich aus der nachfolgenden Beschreibung der Zeichnungen, die Beispiele von Anordnungen zur Durchführung des Verfahrens und der einzelnen Schaltstufen zeigt. Dabei zeigt :

Figur 1   ein Blockschaltbild einer erfindungsgemäßen Anordnung,

Figur 2   eine Meßsignalerzeugungsstufe,

Figur 3   eine Bildschirmanzeige eines Meßwertes,

Figur 4   eine Prinzipschaltung zur Meßsignalerzeugung,

Figur 5   ein Impulsschema zu Fig. 4,

Figur 5a   eine Bildschirmanzeige eines Meßwertes von unten nach oben,

Figur 5b   eine Bildschirmanzeige eines Meßwertes von oben nach unten,

Figur 6   ein Prinzipschaltbild analog Fig. 4 für waagerechte Meßwertdarstellung,

Figur 6a   eine Bildschirmanzeige eines Meßwertes von rechts nach links,

Figur 6b   eine Bildschirmanzeige eines Meßwertes von links nach rechts,

Figur 7   ein Prinzipschaltbild des Meßkanales mit Grenzwertgeber,

Figur 8   eine Meßwertstufe mit Flip-Flop-Stufe,

Figur 9   eine Meßwertstufe mit Monoflop-Stufe,

Figur 10   eine Grenzwertgeberstufe mit einstellbarem Monoflop,

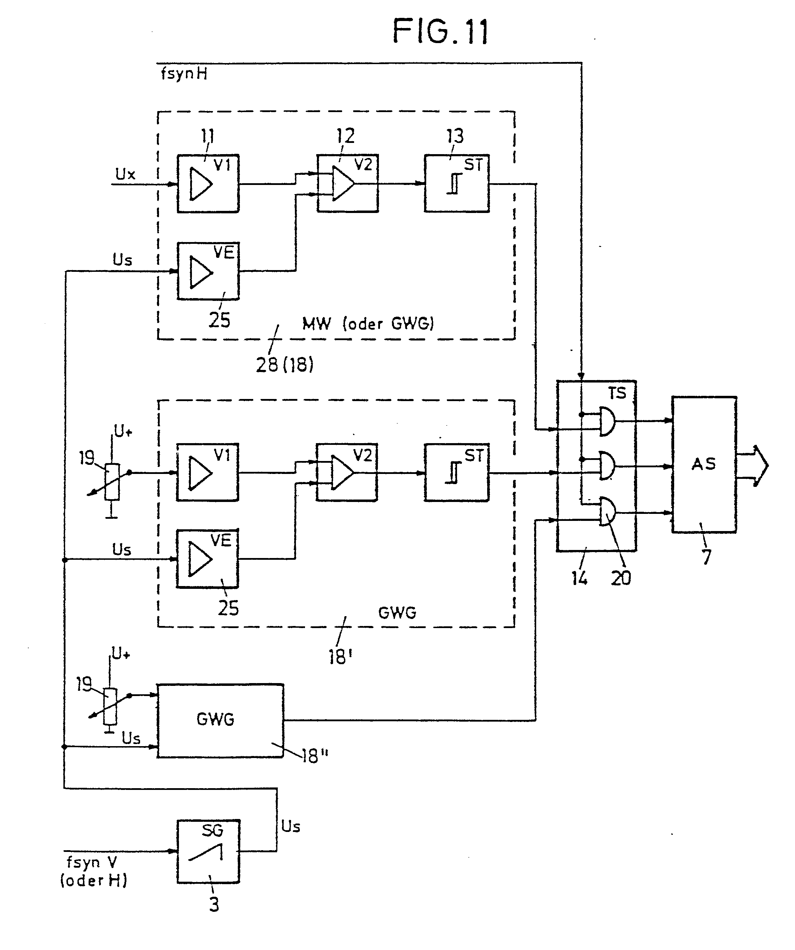

Figur 11   eine Meßkanal gemäß Fig. 7 mit gemeinsamem Sägezahngenerator,

Figur 12 bis 18 Ausführungsbeispiele für Schaltstufen zur Erzeugung des Meßsignales und/oder Grenzwertsignales,

Figur 19   einen Meßkanal mit Grenzwertmarkengeber,

Figur 19a   eine Auswahlschaltung mit Zuordnung von Meßwert und Grenzwerten und Farben.

Figur 20   einen Meßkanal mit Grenzwertmarkengeber und Grenzwertspeicher,

Figur 21   einen Meßkanal mit Torzeitstufe,

Figur 22   zwei Meßkanäle mit DatenBUS und SteuerBUS,

Figur 23   Meßkanäle mit Torzeitzentrale und

Figur 24   ein Blockschaltbild gemäß Fig. 1 mit zusätzlichen Schaltstufen.

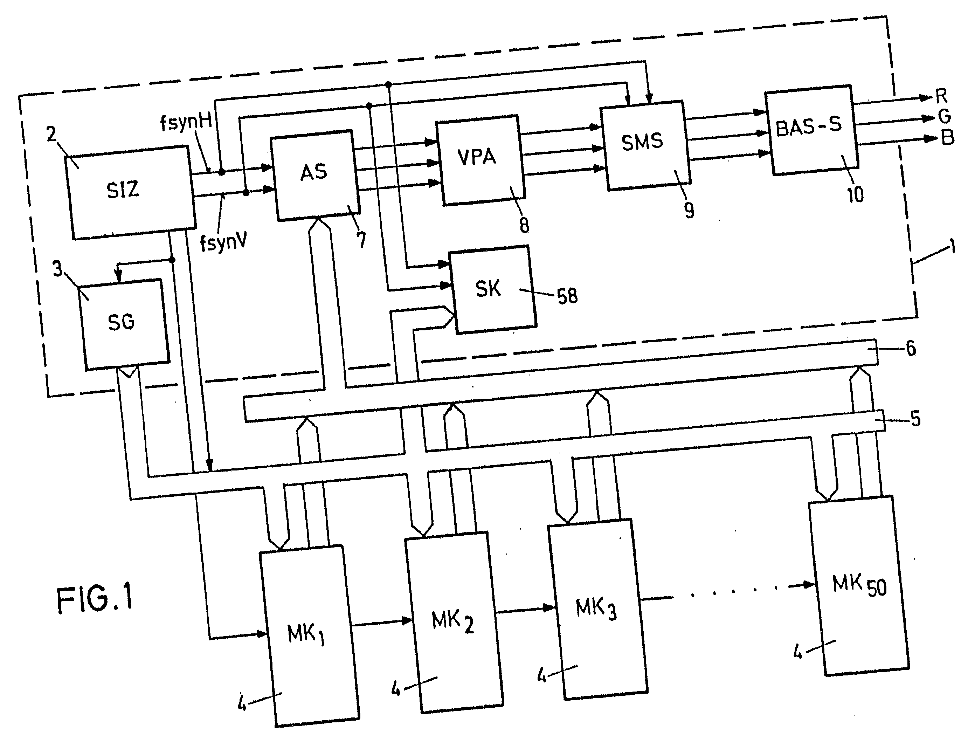

In Fig. 1 ist schematisch ein Blockschaltbild einer Anordnung zum Darstellen eines oder mehrerer Meßwerte beliebiger Meßgrößen auf dem Bildschirm eines nach dem Zeilenrasterverfahren arbeitenden Sichtgerätes dargestellt. Eine derartige Anordnung besteht im wesentlichen aus einer Grundeinheit GE 1 mit einer Synchron-Impuls-Zentrale SIZ 2, die in an sich bekannter Weise Zeilen- oder Bildsynchronimpulse fsynH bzw. fsynV abgibt. Ferner enthält die Grundeinheit 1 eine Auswahlschaltung AS 7, deren Funktion später noch ausführlich beschrieben wird. An diese Auswahlschaltung AS 7 schließt sich eine Videopegelanpassungsstufe VPA 8 an, von der aus ein Videosignal an eine Synchronmischstufe SMS 9 angeschlossen ist, der von der Impulszentrale SIZ 2 die entsprechenden Synchronimpulse zugeleitet werden. In einer RGB-Videosignal-Stufe BAS 10 werden dann die Signale in ein normgerechtes RGB-Signal aufbereitet. In der Grundeinheit GE 1 kann noch zusätzlich ein Sägezahngenerator SG 3 angeordnet sein, dessen Funktion ebenfalls später noch ausführlich erläutert wird. Über einen Steuer-BUS 5 und einen Daten-BUS 6 ist die Grundeinheit mit einzelnen Meßkanälen MK 4 verbunden. Bei einem Ausführungsbeispiel können bis zu 50 MK 4 angeschlossen sein. Eine Skaleneinteilung auf dem Bildschirm 16 wird in einer Skalierungsstufe SK 58 erzeugt und später erklärt.

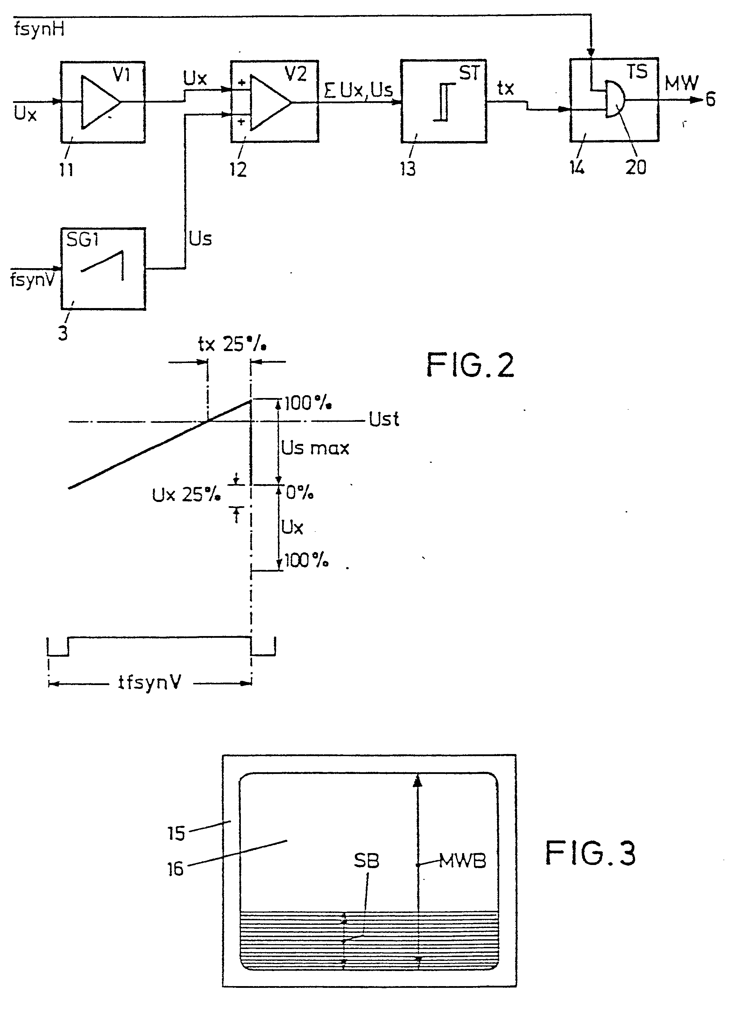

In Fig. 2 ist eine Meßsignalerzeugungsstufe dargestellt, der ein Meßwert als Meßspannung Ux zugeführt wird und die einen Meßwert MW an den Daten-BUS 6 abgibt. Die Meßsignalerzeugungsstufe weist einen Meßspannungsverstärker V1 11 auf, in dem eine Meßspannung Ux auf eine normierte Größe, von z. B. 100 % ≤ 1 Volt gebracht wird. Die normierte Meßspannung Ux wird dann einem Eingang eines Addierverstärkers V2 12 zugeleitet. Vom Sägezahngenerator SG 3 der von einem Bildfrequenzimpuls fsynV gesteuert wird, wird eine hochlineare sägezahnförmige Spannung Us erzeugt und dem zweiten Eingang des Addierverstärkers V2 12 zugeleitet. Der Sägezahngenerator SG 3 kann z. B. nach dem Bootstrap-Verfahren oder dem Miller-Integrationsverfahren betrieben werden. Die Sägezahnspannung Us wird von einer den Bildfrequenzimpulsen entsprechenden Frequenz oder direkt von den Bildfrequenzimpulsen fsynV eines nach dem Zeilenrasterverfahren arbeitenden Bildschirmgerätes synchronisiert. Damit entspricht die Basiszeit der Sägezahnspannung Us der Periodenzeit der Bildwechselfrequenz des Sichtgerätes und der in der Bildwechselimpulsfrequenz möglichst synchronen vielfach enthaltenen Zeilenrasterfrequenz fsynH.

Der Ausgang des Addierverstärkers V2 12 wird in einen Schwellwertschalter ST 13 geleitet, z. B. einen Schmitt-Trigger, der dann durchschaltet, wenn die Summe der Sägezahnspannung Us und der Meßspannung Ux einen bestimmten Schwellwert Ust überschreitet. Damit wird die Meßspannung Ux in ein flankensteiles zeitproportionales Signal tx umgewandelt. Bei Verwendung eines Addierverstärkers V2 12 mit sehr großer Verstärkung kann eventuell der Schwellwertschalter ST 13 entfallen und das Signal tx direkt am Ausgang des Verstärkers V2 12 entnommen werden.

Auch die Sägezahnspannung Us muß entsprechend normiert sein, ebenso der Schwellwert Ust des Schwellwertschalters ST 13. Somit ergibt sich   Uxmax = Usmax = Ust   konstant entsprechend 100 % tx.

Die   entsprechende   Zuordnung   der Spannungen und Signale ist im unteren Teil der Fig. 2 dargestellt. Bei dem dargestellten Beispiel beträgt die Meßspannung Ux etwa 25 % des Meßspannungsvariationsbereiches. Damit wird die Flanke der Sägezahnspannung Us für eine Zeit tx von 25 % der Zeitdauer eines Synchronimpulses fsynV über den Schwellwert Ust angehoben, so daß während der Zeit tx 25 % der Bildschirm an einer zugehörigen Stelle hellgetastet wird.

Das somit der Meßspannung Ux proportional entstehende Zeitsignal tx wird in einer nachfolgenden UND-Stufe (Torschaltung) TS 14 mit einer der Zeilenfrequenz entsprechenden Frequenz oder der Zeilenfrequenz fsynH des nach dem Zeilenrasterverfahren arbeitenden Bildschirmgerätes vergattert und bildet den später auf dem Bildschirm sichtbaren Meßwertbereich. Das Signal, das am Ausgang der UND-Stufe (Torschaltung) TS 14 ansteht, wird, nach entsprechender Pegelanpassung als Y-Signal im BAS-Signal bezeichnet.

In Fig. 3 ist schematisch ein Sichtgerät 15 mit einem Bildschirm 16 dargestellt, wobei auf dem Bildschirm 16 ein Meßwertbereich MWB und ein Signalbereich SB gekennzeichnet sind. Der Signalbereich SB entspricht dem Zeitsignal tx, das aus der Summe der Meßspannung Ux und der Sägezahnspannung Us gebildet wurde.

Wenn, wie zuvor beschrieben, der Sägezahngenerator SG 3 mit dem Bildfrequenzimpuls fsynV (oder Zeilenfrequenzimpuls fsynH) oder einer entsprechenden Frequenz synchronisiert wird und einen steigenden Sägezahnverlauf aufweist, erfolgt die dem Meßwert entsprechende Bildwiedergabe horizontal ansteigend auf dem Bildschirm 16, da wie erläutert, die Summe der Meßspannung Ux und der Sägezahnspannung Us als die Zeit tx durch den zeitlich fortschreitenden Verlauf der fortlaufenden Zeilenfrequenz fsynH bei Beginn der Zeit tx fortlaufend zu den erst später folgenden Zeilen verglichen wird. Damit ist der Meßwertbereich auf dem Bildschirm dargestellt, der senkrecht verläuft. Die Darstellung des Meßwertes beginnt von unten nach oben.

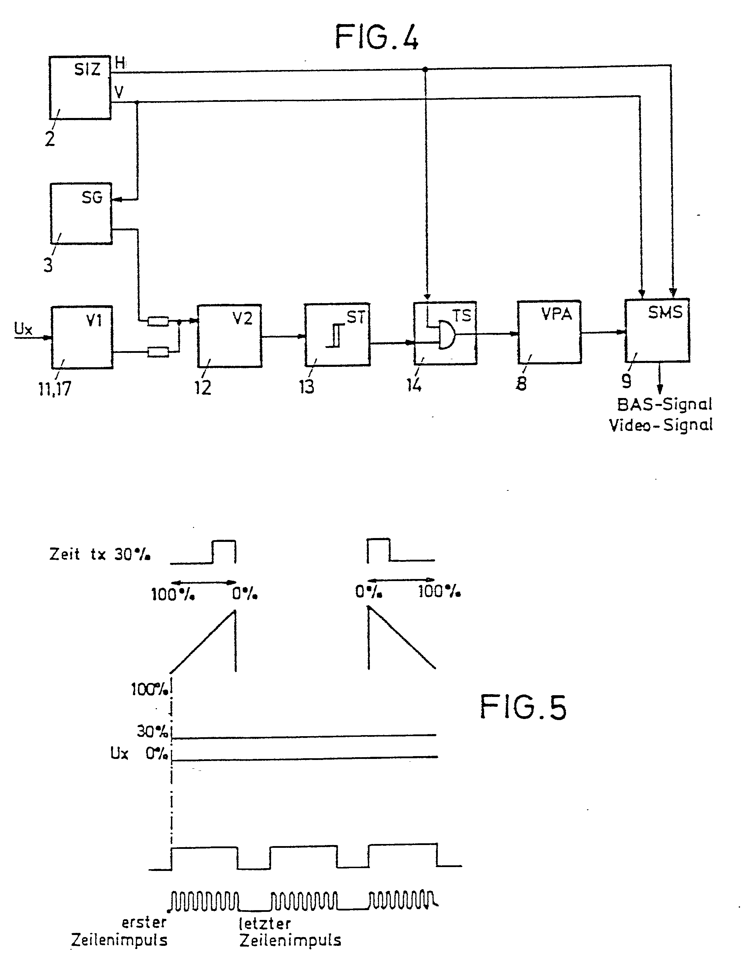

Die Fig. 4 zeigt eine Prinzipschaltung mit einzelnen Schaltstufen der Fig. 1 zur Meßsignalerzeugung. Wie erläutert, wird eine Meßspannung Ux der Meßwertanpassungsstufe 11, 17 mit dem Meßspannungsverstärker V1 11 zugeleitet. Der Sägezahngenerator SG 3 wird von der Synchron-Impuls-Zentrale SIZ 2 in der beschriebenen Weise gesteuert. Das im Summierverstärker V2 12 erzeugte Signal wird in der beschriebenen Weise an den Schwellwertschalter ST 13 geleitet und über eine Torschaltung TS 14 an die Videosignalanpassungsstufe VPA 8. In der nachfolgenden Synchronimpulsstufe SMS 9 wird ein BAS-Signal bzw. ein Videosignal erzeugt und an das Sichtgerät weitergeleitet.

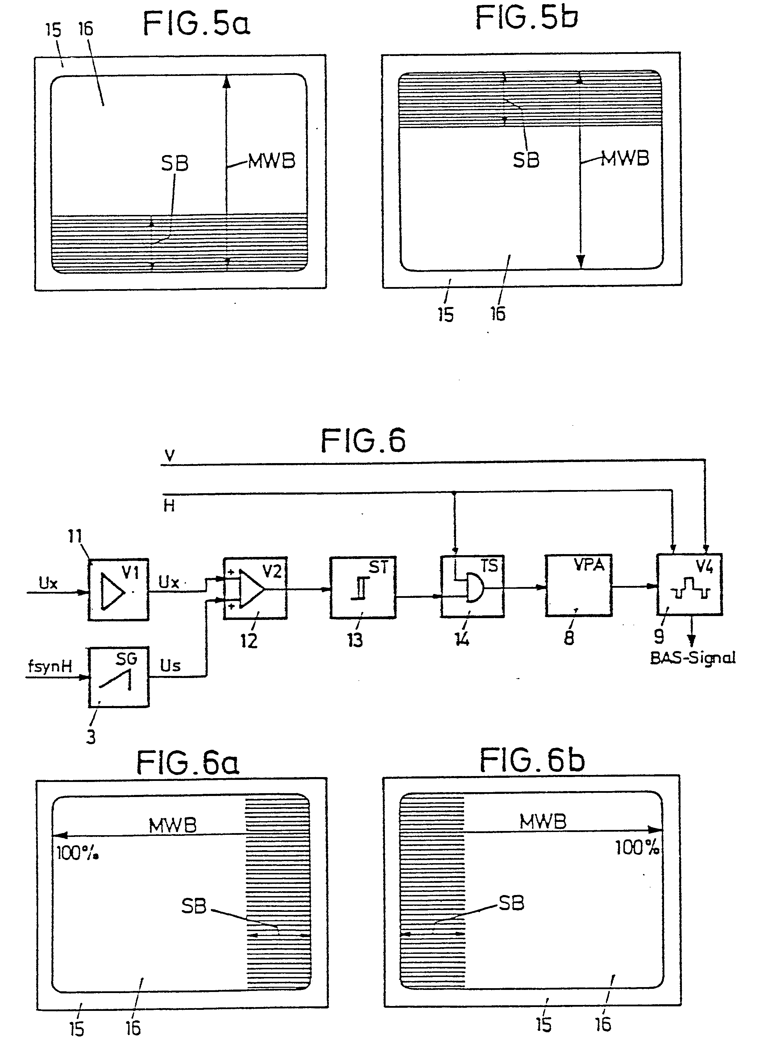

Fig. 5 zeigt ein Impulsschema zu der Prinzipschaltung gemäß Fig. 4. Im linken Teil der Fig. 5 ist die Sägezahnspannung mit steigender Flanke, im rechten Bereich mit fallender Flanke dargestellt. Die Fig. 5a entspricht im wesentlichen der Fig. 3 und zeigt die Darstellung des Meßwertbereiches MWB bzw. Signalbereiches SB auf dem Bildschirm 16 in einem Sichtgerät 15 bei steigender Sägezahnspannung, während Fig. 5b in analoger Weise die Verhältnisse auf dem Bildschirm 16 bei einem fallenden Sägezahn gemäß dem rechten Teil von Fig. 5 darstellt. Wenn, wie zuvor beschrieben, der Sägezahngenerator SG 3 bei abfallenden Sägezahnverlauf mit den Bildfrequenzimpulsen fsynV oder einer den Bildfrequenzimpulsen fsynV entsprechenden Frequenz synchronisiert wird, erfolgt die dem Meßwert entsprechende Bildwiedergabe horizontal ab fallend auf dem Bildschirm, da die Zeit tx durch den zeitlichen Verlauf der fortlaufenden Zeilenfrequenz fsynH mit Beginn der Zeit tx zu erst erscheint.

Wenn die Zeit tx über eine Inverterstufe im einfachsten Fall ein NAND-Gatter, invertiert wird, dann können die zuvor beschriebenen Umkehrungen, bedingt durch steigenden oder abfallenden Sägezahn im Sägezahngenerator SG 3 wieder umgekehrt werden. Somit kann in einfacher Weise die Darstellung der Meßwerte auf dem Bildschirm 16 in allen Achsenrichtungen erfolgen.

In Fig. 6 ist ein Prinzipschaltbild analog Fig. 4 für eine waagrechte Meßwertdarstellung auf dem Bildschirm 16 gezeigt.

Wenn der Sägezahngenerator SG 3 mit der Horizontalfrequenz fsynH synchronisiert wird und einen steigenden Sägezahnverlauf aufweist und die hieraus resultierenden Sägezahnspannung Us mit der Meßspannung Ux nach erfolgter Meßspannungsnomierung im Verstärker V1 11 im Addierverstärker V2 12 addiert wird, entsteht die der Meßspannung proportional verlaufende Zeit tx, wie bereits beschrieben. Wenn diese Zeit tx einen Verstärker V3 in einer Videopegelanpassungs stufe VPA 8 zur Y-Signalanpassung zugeführt wird und in einer nachfolgenden Synchronimpulsstufe V4 SMS 9 der Horizontal- und Vertikalimpuls zugemischt wird, steht am Ausgang dieser Mischstufe 9 ein normgerechtes BAS-Signal videofrequent zur Verfügung. Die Darstellung der umgewandelten und der Zeit tx entsprechenden Meßspannung Ux auf einem Bildschirm 16 erfolgt im zeitlichen Verlauf einer Zeile, bei ansteigendem Sägezahn beginnend am Ende der Zeilen, wie in Fig. 6a dargestellt, bei abfallendem Sägezahn beginnend am Anfang der Zeilen, wie in Fig. 6b gezeigt.

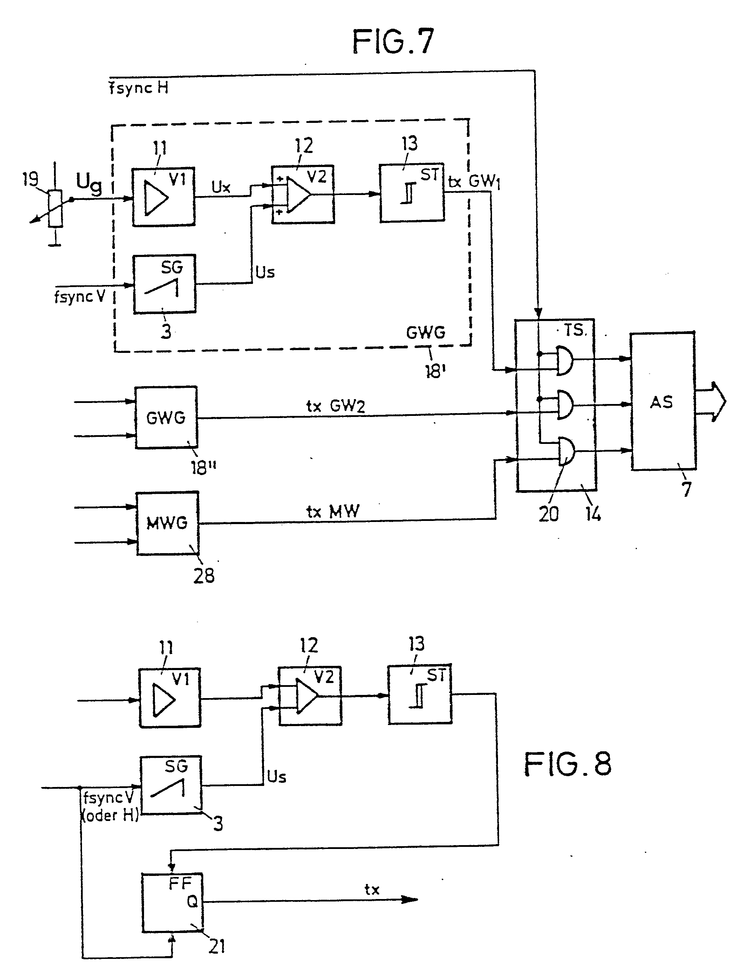

In Fig. 7 ist ein Prinzipschaltbild eines Meßkanals mit einem Grenzwertgeber GWG 18 dargestellt. Die Erzeugung eines dem Grenzwert entsprechenden Zeitsignals tGW erfolgt im Grenzwertgeber 18 in analoger Weise zu der Erzeugung des Meßsignals tx. Dabei wird für jeden Grenzwert ein Grenzwertgeber 18 verwendet, wobei anstelle der Meßspannung Ux eine bekannte, beispielsweise mittels eines Einstellpotentiometers 19 veränderbare Spannung Ug an den Eingang eines Verstärkers V1 11 gelegt wird.

Die Höhe der Spannung entspricht der Zeit und dem geforderten Grenzwert. In einer später beschriebenen nachfolgenden Auswahlschaltung AS 7 wird der Grenzwert GW mit dem Meßwert MW verglichen bzw. die Zeit tGW mit tMW. Falls zwei Grenzwerte erwünscht sind werden zwei Grenzwertgeber 18′, 18″ verwendet. Die erzeugten Grenzwertzeiten tGW 1 bzw. tGW 2 werden in der Auswahlschaltung AS 7 verglichen. Vor der Auswahlschaltung AS 7 ist die bereits erwähnte Torschaltung TS 14 angeordnet, mit der ausgewählt wird, wann ein Meßwert tMW durchgeschaltet wird. Die Torschaltung TS 14 kann beispielsweise aus geeignet geschalteten UND-Gattern 20 aufgebaut sein. Dabei wird die Torschaltung gemeinsam mit der Frequenz fsynH geschaltet, so daß jeder Meß- oder Grenzwertausgang gleichzeitig die Torschaltung passiert. Der Meßwertgeber MWG 28 entspricht der Meßsignalerzeugungsstufe nach Fig. 2.

Gemäß einer Abwandlung der Schaltung nach Fig. 7 kann für die Meßwert- und Grenzwertumwandlung ein einziger gemeinsamer Sägezahngenerator SG 3 Verwendung finden, der alle Meßwert- und Grenzwertgeber 28 bzw. 18', 18" gemeinsam mit einer Sägezahnspannung versorgt. Dieser Sägezahngenerator SG wird in der beschriebenen Weise durch einen Bild- oder Zeilensynchronimpuls fsynV (oder fsynH) synchronisiert. Zum Entkoppeln bzw. zur Anpassung können in den Meßwert- bzw. Grenzwertgebern 28, 18', 18" Entkopplungsverstärker VE 25 vorgesehen sein. Diese können als Operationsverstärker ausgebildet sein, wodurch sich durch z. B. Gegenkopplung leicht eine Linearitätsänderung des Sägezahnsignales Us und damit eine gewollte Linearitätsanpassung der Meßspannung Ux bewirken läßt.

Bei den vorbeschriebenen Schaltungen können anstelle von Sägezahngeneratoren SG auch Treppenspannungsgeneratoren verwendet werden. Die Synchronisation erfolgt in der gleichen Weise wie bei den beschriebenen Sägezahngeneratoren. Bei der Anwendung eines Treppenspannungsgenerators TSG 26, der als bekannt vorausgesetzt wird, ergibt die Anzahl der Treppenstufen eine Schaltpunktfolge, die mit der Auflösung der Meßwertspannung Ux in Zusammenhang steht.

In Abwandlung können die Grenzwertzeiten tGW oder die Meßwertzeit tMW auch mittels monostabiler Kippschaltungen erzeugt werden (Mono-Flop 23), wodurch diese Kippschaltungen durch die Synchronimpulse fsynV (oder fsynH) gestartet werden und für eine Zeitdauer tx ablaufen, die ausschließlich durch Widerstand und Kapazität des Zeitgliedes bestimmt wird.

Bei der Erzeugung der Zeiten Tx durch einen Mono-Flop ist folgende Rahmenbedingung erforderlich : Die maximale Zeit die aus RC bestimmt wird, muß genau dann abgelaufen sein, wenn der nächste Start- bzw. Synchronimpuls fsynV (oder fsynH) startet. Sie entspricht z. B. 0 % der Meßwertzeit tx. Die minimale Zeit, die aus der Zeitkonstante RC bestimmt wird, entspricht 100 % der tx-Zeit. Der Änderungsbereich zwischen 0 % und 100 % der Meßwertzeit tx bildet sen Signalbereich SB. Der Signalbereich SB wird z. B. am Q-Ausgang des Mono-Flop als Zeit tx entnommen. Wenn der Mono-Flop Q̄ Ausgang, also der negierte Ausgang, zur Entnahme der tx Zeit verwendet wird, erfolgt die entsprechende Negierung der Bereichsendwerte 0 % und 100 %.

Durch Veränderung des Widerstandes R, beispielsweise als Potentiometer ausgebildet, können entsprechende Grenzwerte GW gebildet werden. Die Ausgangzeit wird, wie vorstehend beschrieben, als tGW bezeichnet. Wenn der Mono-Flop-Widerstand als Meßwiderstand ausgebildet ist, der durch mechanische Änderung einer Meßgröße, z. B. einer Weglänge verändert wird, ergibt sich am Ausgang die der Meßgröße proportionale Zeit tx. Da der Mono-Flop in diesem Fall als Meßwertgeber dient, ist die Zeit tx gleich einer Meßwertzeit tMW. Die vorbeschriebene Rahmenbedienung ist erforderlich, um einen Meßwertbereich MWB oder Signalbereich SB von C bis 100 % zu bilden.

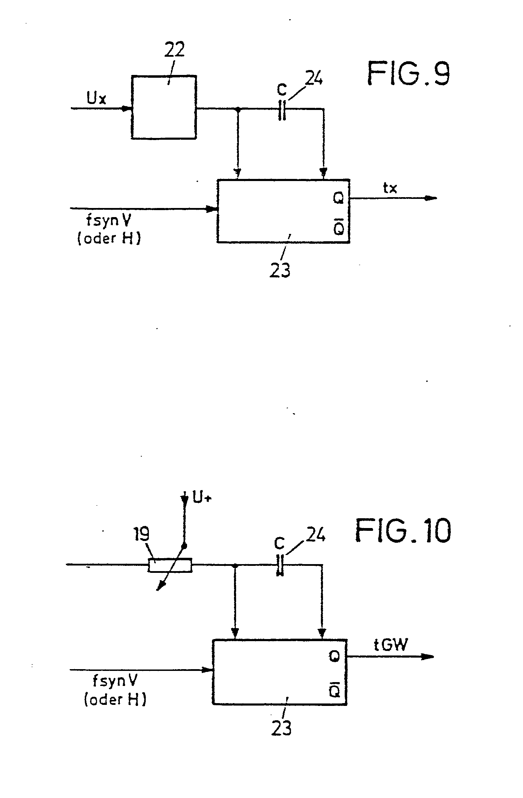

Bei der vorbeschriebenen Mono-Flop-Schaltung kann anstelle des veränderbaren Widerstandes auch eine Konstantstromquelle 22 vorgesehen werden. Dabei ist es möglich, die Konstantstromquelle 22 durch die Meßwertspannung Ux zu steuern bzw. deren Innenwiderstand entsprechend zu verändern. Hierdurch ändert sich analog zum Meßwert bis zum Eintreffen des nächsten Startimpulses die einmalig ablaufende Ausgangzeit tx des Mono-Flops, die der Meßwertzeit tMW entspricht. Hier gelten folgende Rahmenbedingungen : Die maximale Zeit die aus der Konstantstromquelle 22 verändert entsprechend Ux, bestimmt wird, muß spätestens dann abgelaufen sein, wenn der nächste Mono-Flop-Startimpuls fsynV (oder fsynH) ankommt. Die maximale Zeit entspricht 100 % tx, und die minimale zeit entspricht 0 % tx, bei Verwendung des Mono-Flop Q Ausganges. Wenn der Mono-Flop beispielsweise als Meßwertgeber eingesetzt wird, gilt die Ausgangzeit tx als Meßwertzeit tMW. Der Monoflop kann jedoch auch als Grenzwertgeber eingesetzt werden, dann gilt die Ausgangzeit tx als Grenzwertzeit tGW. Eine derartige Anordnung ist in Fig. 9 dargestellt. Die Meßspannung Ux wird einer Konstantstromquelle 22 zugeführt von der ein Kondensator C 24 aufgeladen wird. Ein Mono-Flop 23 wird von dem Bildsynchronimpuls fsynV (oder Zeilensynchronimpuls fsynH) gestartet.

Eine Weiterbildung besteht darin, daß im Meßwertgeber bzw. Grenzwertgeber die Meßwertzeiten tx und Grenzwertzeiten tGW mittels monostabiler Kippschaltungen erzeugt werden. Dabei wird wiederum die monostabile Kippschaltung (Mono-Flop 23) von den Synchronimpulsen der Frequenz fsynV (oder fsynH) gestartet und läuft für die Zeitdauer ab, die auschließlich von R und C bestimmt wird. Diese Anordnung ist in Fig. 10 dargestellt. Dabei ist der Widerstand R 19 als verstellbares Potentiometer gezeichnet.

Eine weitere Möglichkeit einen Meßwert Ux in eine entsprechende Zeit tx umzuwandeln besteht darin, daß über einen Konstantstromschalter 22 ein Kondensator 24 aufgeladen wird, der durch einen Transistor Tr mit dem Synchronimpuls fsynV (oder fsynH) entladen wird. Gleichzeitig wird ein Flip-Flop 21 gesetzt, bei dem zunächst der Ausgang Q « low » ist. Durch die ansteigende Ladespannung am Kondensator C 24 wird bei Erreichen einer bestimmten Schwellspannung Ust der Flip-Flop so gesetzt, daß sein Ausgang Q « high » wird. Die Konstantstromschaltung 22 wird durch eine Meßspannung Ux so gesteuert, daß ihr Innenwiderstand und dadurch die Stromflußabhängigkeit von der Meßspannung Ux geändert wird. Der Änderungsbereich bzw. der entsprechende Meßbereich ist so bemessen, daß z. B. bei Ux gleich 0 der kleinste Ladestrom in den Kondensator C 24 fließt und damit das Erreichen der Schwellspannung Ust gleichzeitig mit dem Beginn des nächsten Synchronimpulses fsynV (oder fsynH) eintritt, bei Ux gleich 100 % tritt der größte Ladestrom in den Kondensator C, wodurch die Schwellspannung Ust schon in kurzer Zeit nach Eintreffen des Synchronimpulses erreicht wird. Die beiden erreichbaren Zustände bilden den Meßwertbereich 0 bis 100 %. Am Ausgang Q des Flip-Flop 21 entspricht die Dauer des « H-Pegels » der Zeit tx bzw. der Meßwertzeit tMW. Durch Verwendung des Flip-Flop Q Ausganges als Meßsignal tx kehren sich die Bereichsendwerte 0 % bzw. 100 % auf der Darstellungsachse um, wie zuvor beschrieben.

Wie im Zusammenhang mit Fig. 8 beschrieben, kann ein Meßwert auch gebildet werden durch Setzen eines Flip-Flops 21 mit dem Synchronimpuls fsynV (oder fsynH) und Rücksetzen mit der Zeit tx, die wie vorher beschrieben, aus der Summe Us plus Ux gebildet wird. Da das Setzen des Flip-Flops gleichzeitig mit dem Start des Sägezahngenerators und das Rücksetzen mit der Zeit tx erfolgt, entspricht die am Ausgang des Flip-Flops 21 anstehende Zeit, auch der Zeit tx. Durch diese Anordnung ergeben sich folgende Vorteile : Wenn nach dem Rücksetzen des Flip-Flops 21 kurzzeitige Spannungseinbrüche in der Meßspannung Ux erfolgen, werden diese bis zum nächsten Setzen des Flip-Flops 21 nicht berücksichtigt und bewirken keine Störungen in der Zeit tx. Außerdem werden steile Schaltflanken erzeugt. Das Flip-Flop 21 kann auch mit der Zeit tx gesetzt und mit dem Synchronimpuls zurückgesetzt werden. Hierbei kehren sich die Bereichsendwerte 0 % und 100 % um, wie bereits zuvor beschrieben.

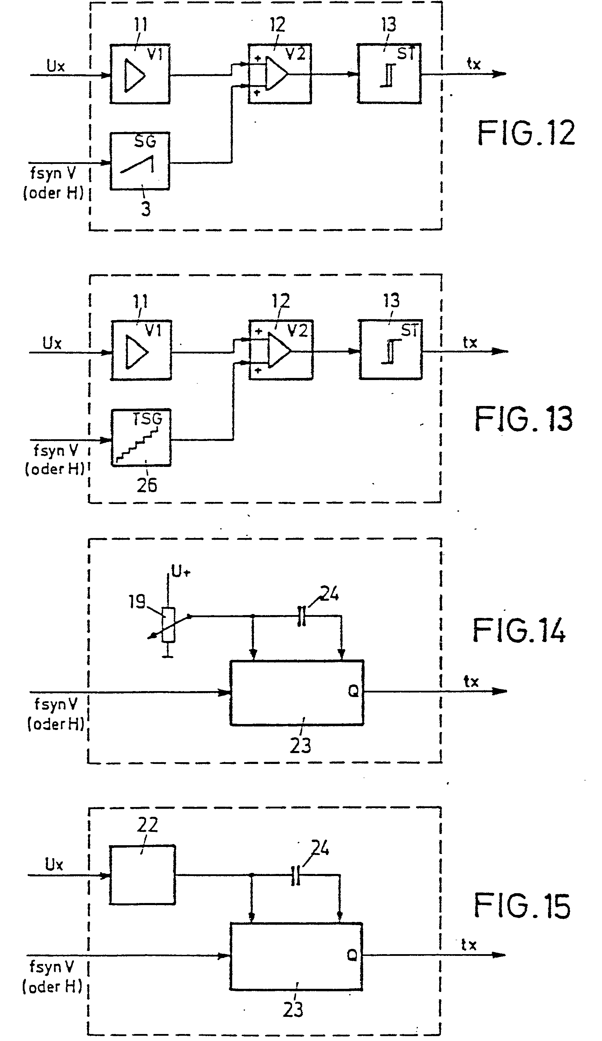

In den Fig. 12 bis 18 sind schematisch Schaltstufen dargestellt, die die verschiedenen Möglichkeiten der Zeitbildung tx zur Verwendung als Meß- oder Grenzwertgeber zeigen. Dabei entspricht Fig. 12 im wesentlichen der Fig. 2, Fig. 13 zeigt eine Abwandlung, bei der anstelle des Sägezahngenerators 3 ein Treppenspannungsgenerator 26 Verwendung findet.

In der Abbildung 14 ist eine Anordnung dargestellt, bei der zur Bildung eines Grenzwertes eine feste Spannung U+, gegebenenfalls veränderbar durch einer Potentiometerwiderstand 19 einem Monoflop 23 zugeführt wird.

In Fig. 15 ist die Erzeugung einer Meßwertzeit tx aus einer Meßspannung Ux mit Hilfe einer durch Ux veränderbaren Konstantstromquelle 22, einem Monoflop 23 und einer Kapazität 24 schematisch gezeigt.

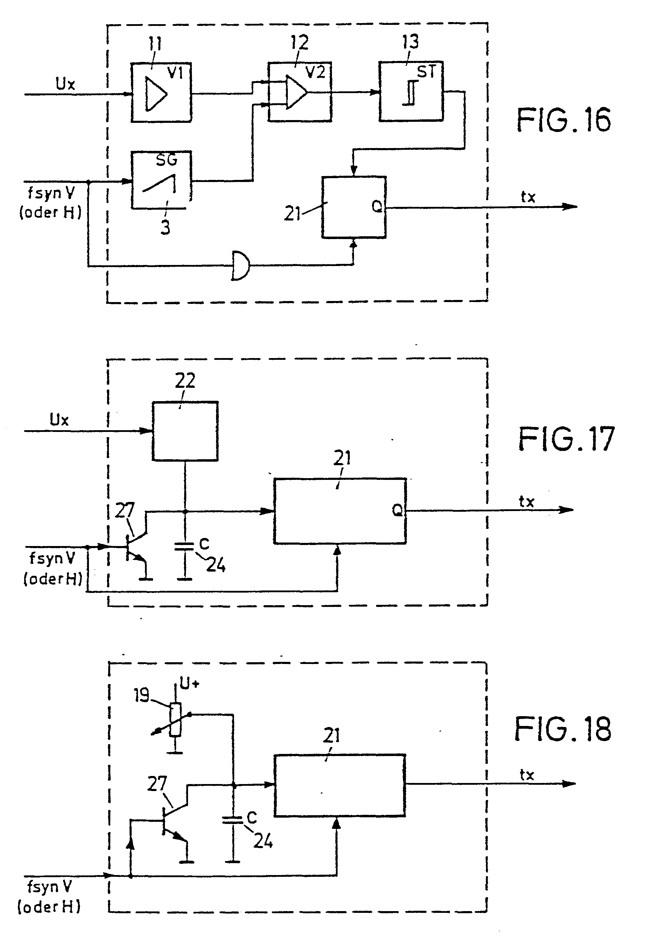

Fig. 16 zeigt die Anwendung eines Flip-Flops 21, um die Meßwertzeit tx unabhängig von eventuellen Störungen oder Schwankungen der Meßspannung Ux während einer Meßzeit zu gestalten.

Die Fig. 17 zeigt die Verwendung eines durch eine Konstantstromquelle 22 versorgten und über einen Transistor 27 entsprechend fsynV oder fsynH gesetzten Flip-Flop 21.

In analoger Weise zeigt Fig. 18 die Erzeugung einer Grenzwertspannung oder Meßwertspannung mit Hilfe einer konstanten Spannung U+, die durch ein Meßpotentiometer 19 verändert und einem Flip-Flop 21 zugeführt wird, dem gleichzeitig über einen Transistor 27 ein Synchronimpuls fsynV oder fsynH zugeführt wird.

Um auf dem Bildschirm 16 anzuzeigen, wo ein Grenzwert gesetzt wurde, ist es erforderlich, falls die Meßspannung Ux zu diesem Zeitpunkt fehlt, eine Grenzwertmarke abzubilden. Dazu dient, nach einer Weiterbildung der vorbeschriebenen Anordnungen ein Grenzwertmarkengeber GWM 31' bzw. 31", der beispielsweise ein Mono-Flop 23 sein kann. Dieser Mono-Flop wird zu Beginn/nach Ablauf mit der Grenzwertzeit tGW gestartet und erzeugt eine Grenzwertmarke der jeweils erwünschten Dauer. Diese Grenzwertmarkenzeit wird dem Meßwertausgang tMW zugeführt. Die Grenzwertmarkenzeit, mit tGWM bezeichnet, wird gleichzeitig dem Meßwertausgang tMW zugeführt. Um Fehlfunktionen in der logischen Schaltung zu vermeiden, ist in zweckmäßiger Weise ein ODER-Gatter 30, das z. B. aus Dioden D1, D2 und D3 gebildet ist, am Grenzwertmarkensignalausgang tGWM und dem Meßwertausgang tMW, vorgesehen.

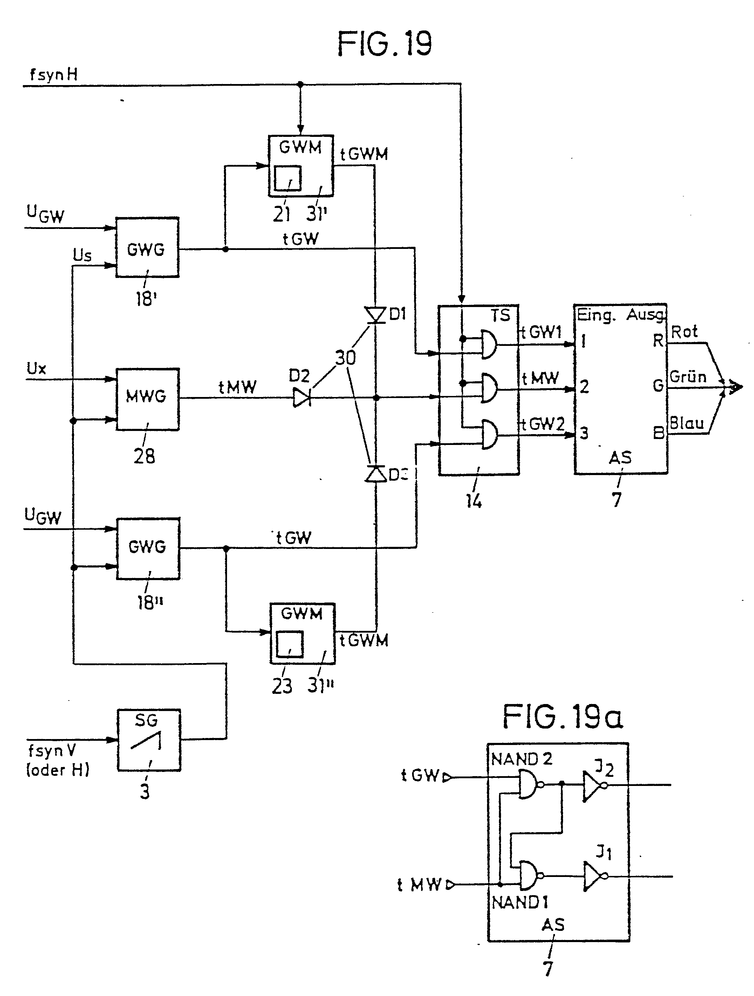

Falls in einem Meßkanal mehrere Grenzwertmarkengeber GWM vorgesehen sind, werden alle von ihnen gebildeten Grenzwertmarkenzeiten tGWM jeweils gemeinsam mit der Meßwertzeit tMW über das ODER-Gatter bzw. Diodengatter 30 verknüpft und gemeinsam dem Meßwerteingang der Torschaltung TS 14 zugeführt. Die Fig. 19, 20, 21, 22 zeigen eine derartige Anordnung. Die Grenzwertmarkenzeit tGWM kann zweckmäßigerweise mit einem Flip-Flop 21 im Grenzwertmarkengeber 31 gebildet werden. Dieses Flip-Flop wird z. B. mit der Grenzwertzeit tGW gesetzt und mit dem Synchronimpuls z. B. fsynH zurückgesetzt. In Fig. 19 ist ein Grenzwertmarkengeber GWM 31' mit einem Flip-Flop 21 und ein Grenzwertmarkengeber GWM 31" mit einem Mono-Flop 23 gezeigt.

Die Grenzwertzeiten werden der Auswahlschaltung AS 7 nach Passieren der Torschaltung TS 14 zugeführt. Die Auswahlschaltung AS 7 ist erforderlich, um auf dem Bildschirm anzuzeigen, um welchen Wert oder Betrag ein gesetzter Grenzwert von der Meßspannung Ux überschritten wurde oder welcher Wert oder Betrag der Meßspannung Ux noch fehlt, um einen gesetzten Grenzwert GW zu erreichen. Ein einfaches Beispiel einer Auswahlschaltung für einen Grenzwert GW und einen Meßwert MW ist in Fig. 19a eingezeichnet. Dabei sind zwei NAND-Gatter vorgesehen sowie zwei Inverter 11 und 12. Die Zeit tMW wird an beide NAND-Gatter geführt und der Ausgang des NAND 2 wird an den Eingang des NAND 1 geführt. Dadurch ist gewährleistet, daß nur dann, wenn die Zeit tMW vorhanden ist, am Ausgang des Inverters I 1 oder I 2 ein « High »-Pegel vorhanden sein kann. Wenn nur die Zeit tMW vorliegt, wird I 1 ein « High »-Pegel aufweisen. Wenn die Zeiten tMW und tGW anliegen, wird der Inverter I 2 einen « High »-Pegel haben. Wenn keine Meßwertzeit tMW anliegt sondern lediglich die Grenzwertzeit tGW, dann werden sowohl I 1 als auch I 2 einen « Low »-Pegel haben.

Im Falle, daß ein Grenzwert gesetzt ist und gleichzeitig keine Meßwertzeit tMW anliegt, wird dieser Grenzwert durch seine Markeinzeit tGWM die der Zeit tMW und der Zeit tGW zugefügt ist, am Ausgangdes Inverters 2, für die Dauer der Grenzwertmarkengeberzeit tGWM, einen « High »-Pegel bewirken.

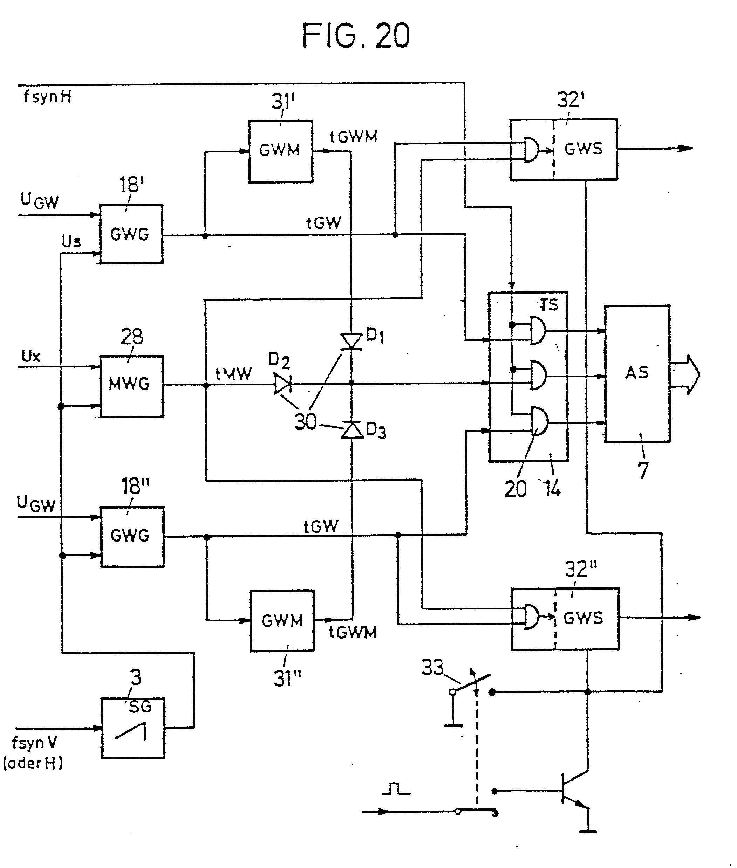

In noch weiterer Ausgestaltung ist es möglich, Überschreitungen von gesetzten Grenzwerten durch die Meßspannung Ux zu speichern. Die Speicherung erfolgt in sog. Grenzwertspeichern GWS 32' bzw. 32", beispielsweise durch Setzen eines Flip-Flops. Der Vergleich der Grenzwertzeit tGW mit der Meßwertzeit tMW bestimmt, wann das Flip-Flops gesetzt wird. Wenn ein Grenzwert und ein Meßwert vorhanden sind, und der Meßwert den gesetzten Grenzwert erreicht oder überschreitet, wird der Flip-Flop des Grenzwertspeichers gesetzt. Im Flip-Flop bleibt die Information, daß der Grenzwert vom Meßwert erreicht wurde, solange gespeichert, bis der Flip-Flop zurückgesetzt wird. Das Zurücksetzen kann entweder von Hand durch Bedienung eines Grenzwertspeicher-Rücksetzschalters 32 oder durch einen impulsgesteuerten Grenzwertspeicherrücksetzschalter bewirkt werden, wie in Fig. 20 gezeigt. Die Ausgänge der Grenzwertspeicher können beispielsweise eine Leuchtanzeige oder ein Relais ansteuern, oder an einem später beschriebenen DatenBUS 6 geleitet werden.

Eine entsprechende Schaltung ist in Fig. 20 dargerstellt.

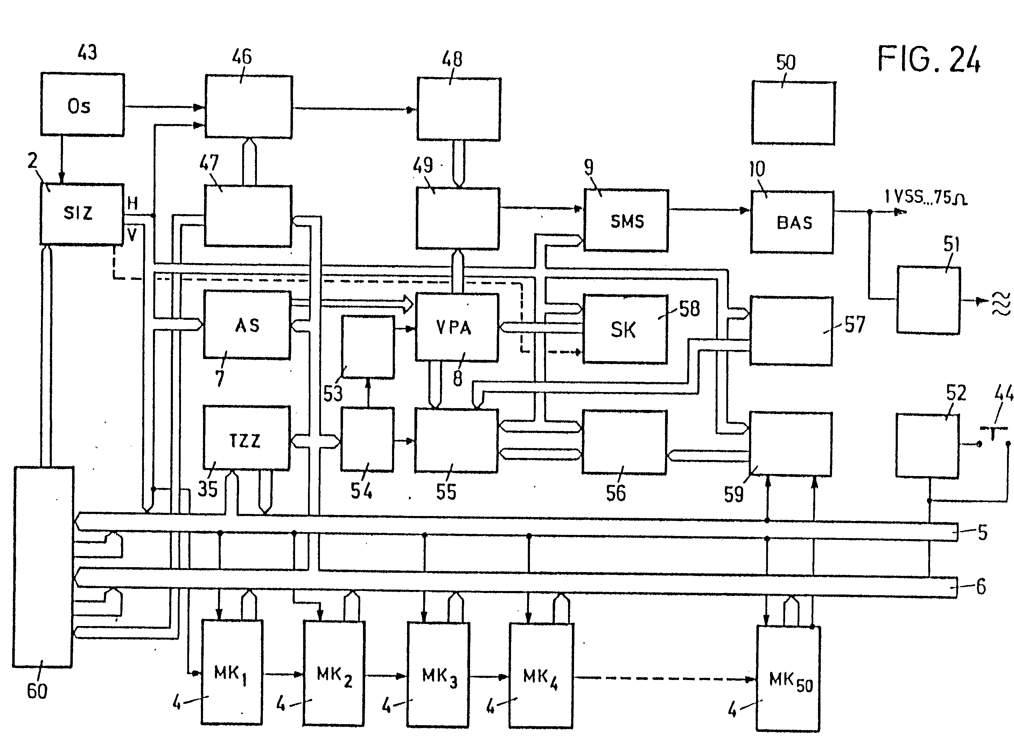

Zum Anzeigen, welchen Wert ein Meßwert auf dem Bildschirm 16 einnimmt, ist eine Skalierungsstufe 58 vorgesehen. Die Skalenlinienerzeugung kann mit an sich bekannten Schaltungen vorgenommen werden. In der Skalierungsstufe 58 können ebenso feste und variable Linien, horizontal oder vertikal auf dem Bildschirm 16 dargestellt, mit den bisher beschriebenen Prinzipien der Grenzwertmarkenzeitbildung tGWM erzeugt werden. Die erzeugten Linien können über die Video-Pegelanpassung 8 dem Videosignal in einem frei bestimmbaren Farbkanal zugeführt werden. Dadurch können die Skalenlinien farbig dargestellt werden. Eine Skalierungsstufe SK 58 ist in Fig. 1 und Fig. 24 gezeigt.

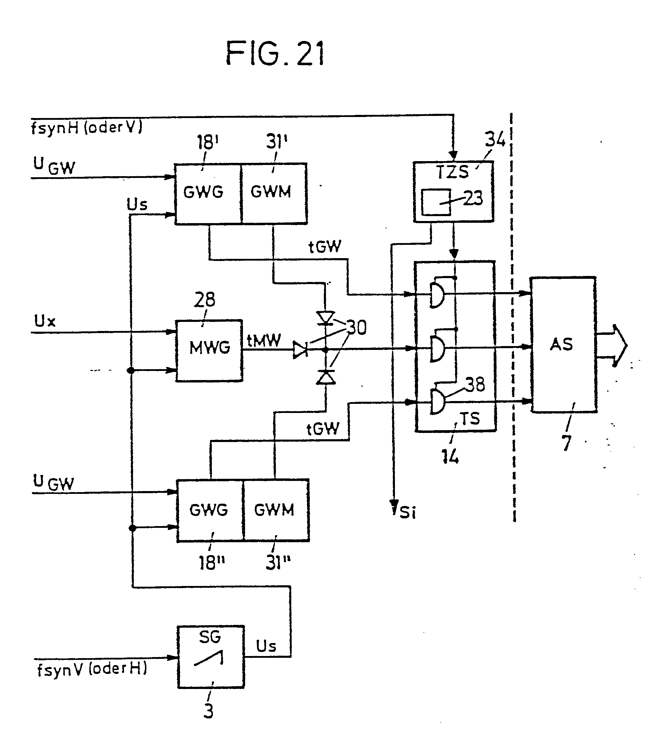

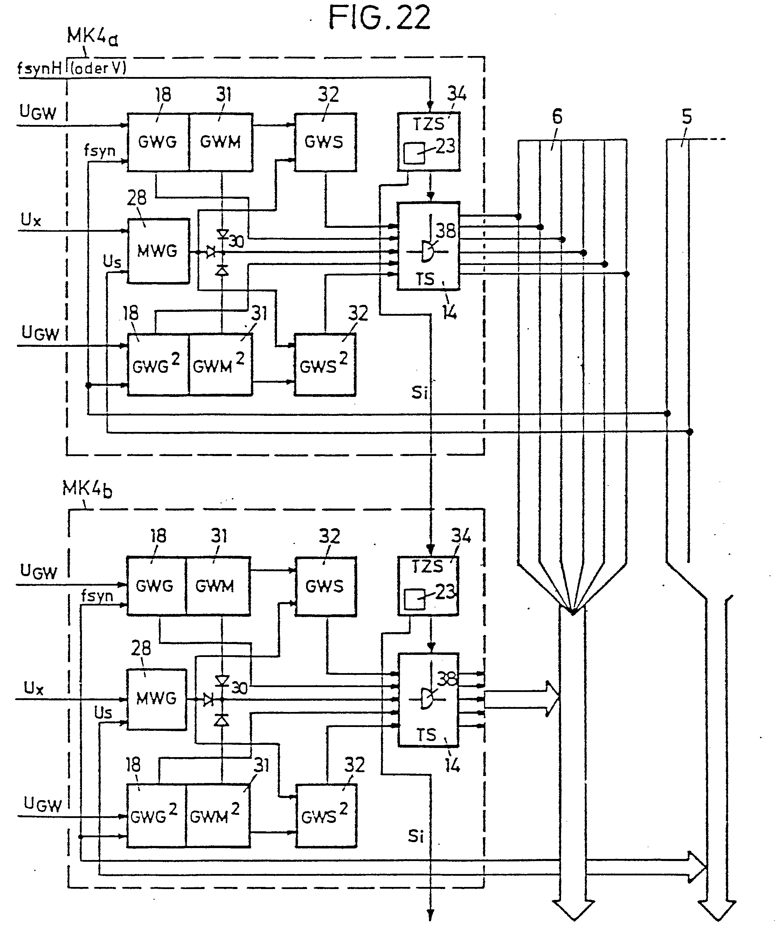

Bei der bisherigen Beschreibung wurde zunächst davon ausgegangen, daß für die Darstellung der Meßwerte oder Grenzwerte oder Grenzwertmarken auf dem Bildschirm 16 eines Sichtgerätes 15 das volle Bildfeld zur Verfügung steht. Es wurde jedoch bereits bei der Beschreibung enzelner Figuren darauf hingewiesen, daß mehrere Meßkanaleinheiten MK 4 vorgesehen sein können, um mehrere Meßgrößen auf dem Bildschirm darzustellen. Um die einzelnen Meßgrößen auf dem Bildschirm eindeutig und übersichtlich voneinander unterscheidbar zu machen, ist es nach einer Weiterbildung zweckmäßig, zur Darstellung der Zeiten tGMW und tGW auf dem Bildschirm nicht die volle Zeilendauer oder Bilddauer auszunützen. Dazu wird eine Torzeitstufe TZS 34 vorgesehen, so daß die anstehenden Zeitsignale des Meßwertes tMW und, falls vorhanden, der Grenzwerte tGW gleichzeitig nur für eine bestimmte Zeitdauer durchgeschaltet werden. Diese Zeitdauer wird im nachfolgenden als tTZ gekennzeichnet und wird in der Torzeitstufe TZS 34 gebildet. Diese Torzeitstufe TZS 34 besteht im wesentlichen aus einem Mono-Flop 23, der mit z. B. dem Zeilenfrequenzimpuls fsynH gestartet wird. Seine Laufzeit entspricht der Torzeit tTZ. Die Torzeit soll jedoch nicht länger sein als dei Zeitdauer einer Zeile. Dadurch ist es möglich, auch einen bestimmten Bereich auf dem Bildschirm 16 für die Darstellung der Meßwerte und/oder Grenzwerte auszunützen bzw. durch Anwendung mehrerer Torzeitstufen beispielsweise je einer Torzeitstufe 34 für jeden Meßkanal 4 mehrere Meßwerte gemeinsam auf dem Bildschirm 16 darzustellen. Dazu ist, gemäß Fig. 21, die im wesentlichen eine Meßkanaleinheit 4 zeigt, in jeder Meßkanaleinheit MK 4 eine Torzeitstufe TZS 34 vorgesehen, die mit dem Torzeitimpuls tTZ auf die Torschaltung 14 wirkt, die Torschaltung TS 34 ist zweckmäßigerweise bei Verwendung von mehreren Meßkanaleinheiten mit 3-states 38 ausgebildet. Zur besseren Übersichtlichkeit sind in Fig. 22 zwei Meßkanaleinheiten 4 MK4a und MK4b dargestellt, wobei die einzelnen an den DatenBUS 6 gelieferten Signalwege eingezeichnet sind und andererseits die einzelnen vom SteuerBUS 5 kommenden Steuersignalwege. An den DatenBUS 6 wird die Torzeit tTZ gegeben, ferner ist der Grenzwertspeicher angeschaltet sowie die Grenzwertgeber GW1 und GW2 ferner wird über die Torschaltung 14 der entsprechende Meßwert tMW und den DatenBUS 6 geliefert. Schließlich kann noch ein zweiter Grenzwertspeicher GWS 2 und ein zweiter Grenzwertgeber GWG 2 mit dem DatenBUS 6 verbunden sein. In jeder Meßkanaleinheit MK4 ist dazu die Torschaltung TS 14 entsprechend erweitert.

Der SteuerBUS 5 bekommt seine Signale von der (nicht dargestellten) Grundeinheit 1 und gibt an die einzelnen Stufen jeder Meßkanaleinheit 4 in der zuvor beschriebenen Weise Synchronsignale fsynV bzw. fsynH ab und die Sägezahnspannung Us.

In den Grenzwertspeichern GWS gespeicherte Zustände werden über die Torschaltung TS 14 gegeben und ebenso wird die von der Torzeitstufe TSZ 34 gebildete Torzeit tTZ über die Torschaltung 14 weitergeleitet. Alle von der Torschaltung 14 durchgeschalteten Meß- und Grenzwerte sowie Signale bzw. Daten werden durch die von der Meßkanaleinheit 4 geschaltete Zeitdauer bestimmt und während dieser Dauer auf den DatenBUS 6 gegeben. Der DatenBUS 6 sammelt alle vorher beschriebenen Daten einer Meßkanaleinheit 4 gleichzeitig, also parallel.

Die Torzeitstufen TZS 34 sind dabei derart ausgebildet, daß dann wenn die von einer Meßkanaleinheit MK4a geschaltete Zeitdauer abgelaufen ist, die Torschaltung TS 14 dieser Meßkanaleinheit abgeschaltet wird, wobei gleichzeitig ein Startimpuls Si zum Einschalten einer nächsten Meßkanaleinheit MK4b an diese abgegeben wird.

Die für alle Meßkanaleinheiten MK 4 gemeinsame Auswahlschaltung AS 7 befindet sich in der Grundeinheit GE 1.

Die Auswahlschaltung AS 7 hat die Funktion, zu verhindern, daß an ihren Eingängen möglicherweise gleichzeitig anstehende Signale gleichzeitig an ihren Ausgängen auftreten. Dazu bestimmt die Auswahlschaltung durch die logische Verknüpfung der Eingangssignale, die aus den Zeiten Meßwertzeit tMW und Grenzwertzeit tGW1 (und bei Verwendung eines zweiten Grenzwertgebers tGW2) bestehen, daß nur eine bestimmte Eingangssignalkombination an einem dieser Kombination zugeordnetem Ausgang der Auswahlschaltung AS 7 als Ausgangssignal auftreten kann. Die Zuordnung kann beispielsweise derart getroffen werden, daß die Grenzwertzeit tGW 1 dem Eingang 1 und dem als R bezeichneten Ausgang zugeordnet ist, die Meßwertzeit tMW dem Eingang 2 und dem als G bezeich neten Ausgang sowie die zweite Grenzwertzeit tGW 2 dem Eingang 3 und dem als B bezeichneten Ausgang zugeordnet ist. Eine Auswahlschaltung mit der Zuordnung ist in Fig. 19 gezeigt. Die Ausgänge R, G und B entsprechen den Farbkanälen eines Farbbildschirm- bzw. Sichtgerätes 15, das durch die vereinbarte Zuordnung die Grenzwertzeit tGW 1 in der Farbe ROT darstellt, die Meßwertzeit tMW in der Farbe GRÜN und die Grenzwertzeit tGW 2 in der Farbe BLAU. Die Auswahlschaltung ist nach den Gesetzen der Boolschen Algebra aufgebaut.

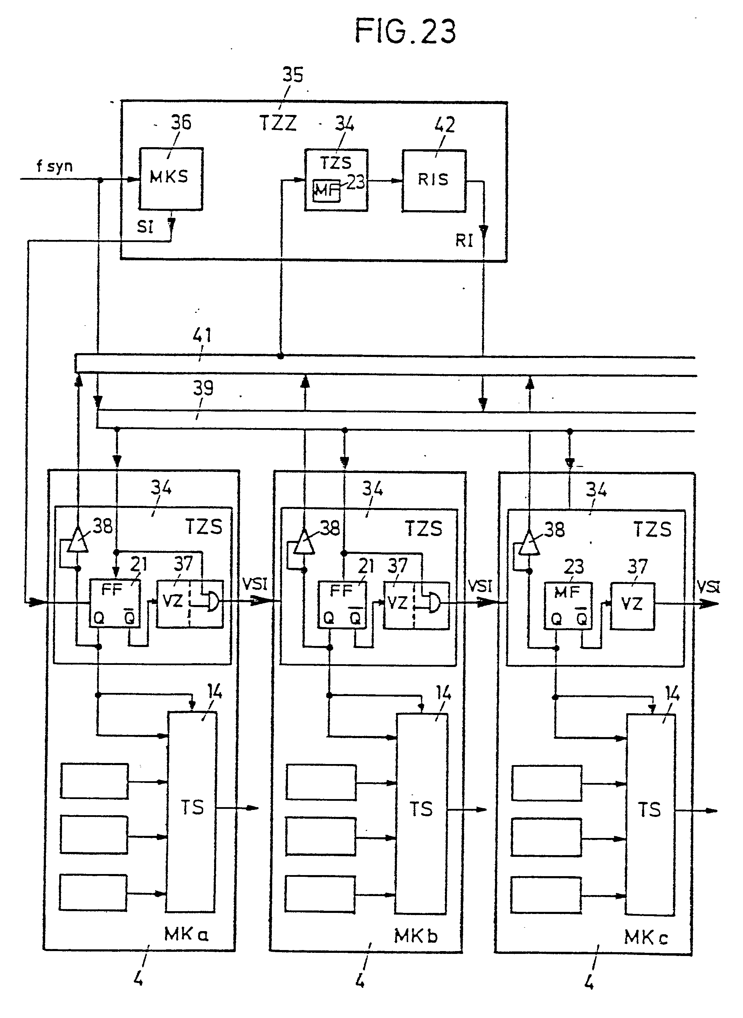

Gemäß einer Weiterbildung der Meßkanaleinheiten 4 und der Grundeinheit 1 sind in den Meßkanaleinheiten 4 die Torzeitstufen TZS 34 mit einem Flip-Flop FF 21 und einer später beschriebenen Verzögerungsschaltung VZ 37 ausgebildet, wie in Fig. 23 in den Meßkanaleinheiten MK4a/b/c gezeigt. Die Bildung der Torzeit tTZ wird in dieser Weiterbildung in einer Torzeit-Zentrale TZZ 35 vorgenommen, die in der Grundeinheit angeordnet ist. In der Torzeit-Zentrale TZZ 35 ist eine Meßkanalstartstufe MKS 36, und eine Rücksetzimpulsstufe RIS 42 sowie eine Torzeitstufe TZS 34 angeordnet. Diese Torzeitstufe bildet die Torzeit tTZ wie die Torzeitstufen TZS 34 in den früher beschriebenen Meßkanaleinheiten, mit einem Mono-Flop 23. Dieses Mono-Flop bildet jetzt zentral die Torzeit tTZ für die Meßkanaleinheiten MK4, die in ihren Torzeitstufen TZS 34 ein Flip-Flop 21 angeordnet haben. Das Flip-Flop 21 in der Torzeitstufe TZS 34 in einer Meßkanaleinheit MK4 bestimmt z. B. mit seinem Q-Ausgang, daß die Torschaltung TS 14 in der Meßkanaleinheit MK4 im Falle Q « Low » z. B. geschlossen und im Falle Q « High » geöffnet ist. Der Q Ausgang schaltet proportional zum Q Ausgang und wird über die Verzögerungsstufe VZ 37 an die jeweils nachfolgende Meßkanaleinheit geleitet und bewirkt dort den Anstoß für die Bildung der nächsten Torzeit tTZ. Ein Vorteil dieser Weiterbildung liegt darin, daß die Meßkanaleinheiten MK4 mit Flip-Flop 21 in den Torzeitstufen TZS 34 alle eine gleiche Torzeit tTZ annehmen. Diese Torzeit tTZ wird zentral in der Torzeitzentrale TZZ 35 durch die dort angeordnete Torzeitstufe TZS 34 mit dem dort befindlichen Mono-Flop 23 gebildet.

Die Torzeit tTZ für eine oder für viele Meßkanaleinheiten MK4, die durch einen Synchronimpuls z. B. fsynH in der ersten Meßkanaleinheit MK4a gestartet wird, muß bis zum Eintreffen des nächsten Synchronimpulses an der ersten Meßkanaleinheit, beendet sein.

Zum Start des Torzeitablaufes aller Meßkanaleinheiten werden zuvor alle Flip-Flops 21 in den Torzeitstufen TZS 34 der Meßkanaleinheiten MK4 über eine zentrale Resetleitung 39, die dem SteuerBUS 5 in der Grundeinheit zugeordnet ist, mit dem Synchronimpuls z. B. fsynH auf Q « Low » gesetzt. Nach Ablauf dieses Rücksetzvorganges wird (ebenfalls vom Synchronimpuls abgeleitet) die Meßkanalstartstufe MKS 36 einen ersten Startimpuls bilden der in Fig. 23 z. B. mit Si gekennzeichnet ist. Dieser Startimpuls Si ist nur an die erste Meßkanaleinheit geführt. Mit dem Startimpuls Si wird nur das Flip-Flop 21 der Torzeitstufe TZS 34 in der ersten Meßkanaleinheit MK4a auf Q « High » gesetzt. Damit wird dort gleichzeitig die Torschaltung TS14 eingeschaltet (womit die Daten der Meß- und Grenzwerte auf den DatenBUS 6 gegeben werden) und ebenso gleichzeitig mit dem Setzen des Flip-Flop 21 auf Q « High »-Pegel, wird dieser Pegel über eine in der Meßkanaleinheit MK4 hierfür bestimmte Diode bzw. ein 3-state 38, einer Meßkanalzahlleitung 41, die dem SteuerBUS 5 in der Grundeinheit angeordnet ist, zugeleitet. Die Anordnung des 3-state 38 in den Torzeitstufen TSZ 34 in den Meßkanaleinheiten MK4 und die Meßkanalzahlleitung 41 und die bereits beschriebene zentrale Resetleitung 39, ist in Fig. 23 gezeigt.

Die Meßkanalzahlleitung 41 wird den zuvor beschriebenen Q « High »-Wechsel der ersten Meßkanaleinheit MK4a an die Torzeitzentrale TZZ 35 weiterleitung, um dort in der Torzeitstufe TZS 34 im Mono-Flop 23 die Torzeit tTZ zu bilden. Nach Ablauf dieser Torzeitstufe TZS 34 in der Torzeitzentrale TZZ 35 wird in der Resetimpulsstufe RIS 42 ein Resetimpuls RI gebildet. Der Resetimpuls Ri wird über die zentrale Resetleitung 39 an alle Meßkanaleinheiten geführt und bewirkt dort, daß nur ein auf Q « High » gesetztes Flip-Flop 21 in den Torzeitstufen TZS 34 der Meßkanaleinheiten MK4 auf Q « Low »-Pegel gesetzt wird. Dadurch wird die Torzeit tTZ der ersten Meßkanaleinheit MK4a beendet und gleichzeitig wird ein Startimpuls gebildet und über eine geeignete Verzögerungsschaltung VZ 37 als verzögerter Startimpuls VSi gekennzeichnet, an die nächste nachfolgende Meßkanaleinheit MK4b geleitet und setzt dort die Torzeitstufe TZS auf « High »-Pegel, wodurch die nächste Torzeitbildung eingeleitet wird. Wenn alle Meßkanaleinheiten durchlaufen sind, leitet der nächste Synchronimpuls an der ersten Meßkanaleinheit den Zyklus neu ein.

Werden bei Anwendung von mehreren Meßkanaleinheiten MK4 mehrere Meßwerte auf dem Bildschirm 16 sichtbar dargestellt, sind zwischen den Abbildungen der Meßwerte auf dem Bildschirm zunächst undefinierte Abstände untereinander sichtbar. Diese Abstände werden durch Zeitpausen gebildet, die während des Umschaltens der Flip-Flops 21 in den Torzeitstufen 34 in den Meßkanaleinheiten MK4 entstehen.

Diese Zeitpausen und damit die Abstände sind relativ kurz und können zwischen einzelnen Meßkanälen auch unterschiedlich lang sein. Werden z. B. dynamische J-K-Flip-Flops 21 in den Torzeitstufen 34 in den Meßkanaleinheiten MK4 verwendet, muß die Zeit des Resetimpulses RIS kürzer sein als die Laufzeiten in den Flip-Flops. Um diese Nachteile zu vermeiden, ist in Weiterbildung der Erfindung, eine geeignete Verzögerungsschaltung zwischen den Meßkanaleinheiten eingefügt. Die Verzögerungsschaltung VZ 37 ist zweckmäßigerweise in den Torzeitstufen TZS 37 in allen Meßkanaleinheiten MK4 angeordnet, wie in Fig. 23 gezeigt. Die Verzögerungsschaltung VZ 37 verzögert die Weitergabe der in den Meßkanaleinheiten MK4 gebildeten Startimpulse Si an die nächste Meßkanaleinheit für eine in der Verzögerungsschaltung bestimmbare Zeitdauer. Der in der Verzögerungsschaltung VZ 37 verzögerte Startimpuls ist mit VSi gekennzeichnet. Wird der verzögerte Startimpuls VSi z. B. für die Zeitdauer von 0,5 Sec. verzögert und dann an die nachfolgende Meßkanaleinheit MK4b weitergeleitet, beträgt der Abstand zur nächsten Meßwertabbildung auf dem Bildschirm 16 dargestellt, 0,5 Sec.

Zweckmäßigerweise ist der in der Verzögerungsschaltung VZ 37 verzögerte Startimpuls VSi über ein UND-Gatter 20 welches z. B. im Ausgang der Verzögerungsschaltung VZ 37 angeordnet ist, mit dem Resetimpuls Ri verknüpft, wie in Fig. 23 in den Meßkanaleinheiten MK4a und MK4b gezeigt. Hierdurch ist die Verzögerungzeit des verzögerten Startimpulses VSi für alle Meßkanaleinheiten MK4 mit einer Verzögerungsschaltung VZ 37 und einem UND-Gatter 20 am Ausgang der Verzögerungsschaltung VZ 37, mit dem Resetimpuls Ri definierbar.

Wird gemäß einer Weiterbildung der Meßkanaleinheit MK4 mit einem Mono-Flop 23 in der Torzeitstufe 34 z. B. am Mono-Flop Q Ausgang ein 3-state 38 so angeordnet, daß der Q « High »-Ausgang des Mono-Flops an die Meßkanalzahlleitung 41 führt und ist für den Startimpuls eine Verzögerungsschaltung 37 eingefügt, können die Meßkanaleinheiten 4 mit Flip-Flop 21 oder Mono-Flop 23 in den Torzeitstufen 34 gemeinsam in einer Grundeinheit mit Torzeitzentrale 35 eingesetzt werden. Hierdurch sind unterschiedliche und gemeinsame Torzeiten zum Abbilden von Meßwerten in Form von Balken auf dem Bildschirm 16 möglich, z. B. Gruppen mit gleichbreiten Meßbalkenabbildungen und einzelnen unterschiedlich breiten Meßbalkenabbildungen.

Eine unterschiedliche Anordnung von Meßkanaleinheiten ist in Fig. 23 dargestellt. Meßkanaleinheit MK4a und MK4b haben Flip-Flops FF 21 in den Torzeitstufen TZS 34 und bilden gleiche Torzeiten tTZ mit der Torzeitzentrale TZZ 35. Die Meßkanaleinheit MK4c bildet die Torzeit tTZ in dem Mono-Flop 23 in der eigenen Torzeitstufe TZS 34. In den Meßkanaleinheiten MK4a, MK4b ist die Verzögerungsschaltung VZ 37 mit UND-Gatter 20 und dem Resetimpuls Ri verknüpft. In der Meßkanaleinheit MK4c ist die Verzögerungsschaltung VZ 37 ohne UND-Gatter 20 gezeigt.

In Fig. 24 ist eine vollständige Anordnung dargestellt, wobei zusätzlich zu den beschrieben Einheiten in der Grundeinheit GE 1 noch ein Netzteil 50 für die zentrale Stromversorgung vorgesehen ist. Der SteuerBUS 6 und der DatenBUS 6 können ebenfalls in der Grundeinheit GE 1 integriert sein. An diesem SteuerBUS 5 und DatenBUS 6 können die einzelnen Meßkanaleinheiten MKi (z. B. 1...50) angeschlossen sein, wobei die Meßkanaleinheiten MK4 als mechanische abgeschlossene Module aufgebaut und in die Grundeinheit GE einsteckbar ausgebildet sein können. In der Grundeinheit 1 sind ferner die bereits beschriebene Videopegelanpassung 8, die Synchronimpulsmischstufe SMS 9 und die Videosignalstufe 10 vorgesehen. Zusätzlich kann eine Skalierungsstufe 58 vorgesehen sein, die auf dem Bildschirm feste und verschiebbare Skalenlinien z. B. nach dem Prinzip der Grenzwertmarkenbildung erzeugt. Ferner kann ein Schriftgenerator 55 vorgesehen sein, wobei eine Meßkanalerkennungsstufe 53 mit einem Meßkanal-Nummernzähler 54. Der Schriftgenerator 55 ist über einen BCD-Wandler 56 mit einer Pegelmeßstufe 59 zum Anzeigen der Meßwerte in Zahlen auf dem Bildschirm verbunden. Zusätzlich kann noch eine Uhr-Datum-Einheit 57 angeschlossen sein. Um den Rücksetzimpuls für die einzelnen Grenzwertspeicher zu erzeugen, ist eine Auto-Grenzwertspeicher-Rücksetzstufe 52 vorgesehen, die ihre Impulse an die Grenzwertspeicher in den Meßkanaleinheiten abgibt. Ein von Hand betätigbarer Resetschalter 44 ist zweckmäßig vorgesehen.

In einem Oszillator OS 43 wird die erforderliche Grundfrequenz für die Synchronimpulszentrale SIZ 2 erzeugt. In der Synchronimpulszentrale werden die erforderlichen Impulse und auch die Sägezahnspannung US erzeugt. Zwischen den Meßkanaleinheiten MK1...50 werden die Startimpulse Si oder die verzögerten Startimpulse VSi je nach Art der Meßkanaleinheit an die nachfolgende Meßkanaleinheit weitergeleitet.

Schließich ist es noch vorteilhaft, wenn eine Datenschnittstelle 60 vorgesehen ist, zur Verbindung mit einer (nicht dargestellten) Datenverarbeitungseinheit.

Das Videosignal kann, beispielsweise bei Verwendung eines nach dem NTSC-, PAL- oder SECAM-Verfahren ausgestalteten Bildschirmgerätes in der Videosignalstufe 10 nach entsprechender Normen-Wandlung in normierter Spannung von 1 VSS an 75 Ohm abgenommen werden. Es ist aber auch möglich, eine Hochfrequenzstufe 51 vorzusehen, die ein hochfrequentes Bildsignal abgibt, das an die Antennenbuchse eines entsprechenden Monitors oder Farbfernsehgerätes geschaltet werden kann.

In an sich bekannter Weise ist auch noch eine Farbartbestimmungsstufe 46 und eine Farbpegelgewinnungsstufe 47 vorgesehen sowie eine Farbendstufe 48 und eine Farb- und Videomischstufe 49. Diese letztgenannten Stufen sind in an sich bekannter Technik aufgebaut und bedürfen daher keiner näheren Erläuterung.

**Patentansprüche**

1. Verfahren zum vertikalen oder horizontalen Darstellen eines oder mehrerer Meßwerte beliebiger Meßgrößen auf dem Bildschirm eines nach dem Zeilenrasterverfahren arbeitenden Sichtgerätes, insbesondere eines Farbbildschirmgerätes, bei dem in einem Synchronimpulsgenerator Zeilen- und Bildfrequenzimpulse erzeugt werden, dadurch gekennzeichnet, daß eine jeder Meßgröße entsprechende Meßspannung (Ux) gebildet und in einem Meßspannungsverstärker (V1) zunächst normiert und dann einem Addierverstärker (12) zugeführt wird, dem gleichzeitig eine sägezahnartig verlaufende Spannung (Us) zugeführt wird, daß die sägezahnartige Spannung (Us) von den Bild- oder Zeilenfrequenzimpulsen (fsynV bzw. fsynH) oder einer den Bild- bzw. Zeilenfrequenzimpulsen entsprechenden Frequenz synchronisiert wird und die Ausgangsspannung des Addierverstärkers einem Schwellwertschalter zugeführt wird, der bei Überschreiten des Schwellwertes durch die Summenspannung ein der Meßspannung zeitproportionales Signal (tx) abgibt, wobei für die Meßwertabbildung auf dem Bildschirm von unten nach oben bei vertikaler Darstellung bzw. von rechts nach links bei horizontaler Darstellung eine Sägezahnspannung (Us) mit ansteigender Flanke oder für die Abbildung von oben nach unten bei vertikaler Darstellung bzw. von links nach rechts bei horizontaler Darstellung eine Sägezahnspannung mit abfallender Flanke benutzt wird, daß das der Meßspannung proportionale Signal (tx) einer nachfolgenden, mit den Zeilen- bzw. Bildfrequenzimpulsen (fsynH bzw. fsynV) synchronisierten Torschaltung (14) zugeleitet und nach Pegelanpassung und Synchronimpulsmischung als Videosignal (BAS-Signal) dem Sichtgerät zugeleitet wird.

2. Verfahren nach Anspruch 1, dadurch gekennzeichnet, daß der Torschaltung (14) zusätzlich ein Grenzwertsignal zugeführt wird, das durch Zufuhr einer einstellbaren festen Spannung (Ug) an einen Addierverstärker, dem andererseits eine sägezahnartige Spannung (Us) zugeführt wird, die vom Bild- bzw. Zeilensynchronimpuls (fsynV, fsynH) synchronisiert ist, und analog der Meßsignalerzeugung durch einen Schwellwertschalter ein dem Grenzwert zeitproportionales Grenzwertsignal (tGW) erzeugt.

3. Verfahren nach Anspruch 2, dadurch gekennzeichnet, daß die sägezahnartige Spannung (Us) für die Bildung des Meßwertsignales (tx) und die Bildung des Grenzwertes (tGW) durch einen gemeinsamen Sägezahngenerator gebildet wird.

4. Verfahren nach Anspruch 2 oder 3, dadurch gekennzeichnet, daß zur Abbildung einer Grenzwertmarke auf dem Bildschirm des Sichtgerätes bei fehlender Meßspannung oder einer Meßspannung kleiner als der Grenzwert ein der Grenzwertmarke zeitproportionales Grenzwertmarkensignal (tGWM) erzeugt und dem Meßwertsignal (tx) und der Torschaltung zugeführt wird.

5. Verfahren nach Anspruch 4, dadurch gekennzeichnet, daß bei Überschreiten eines vorgegebenen Grenzwertes durch das Meßsignal (tx) ein Grenzwertspeicher aktiviert wird.

6. Verfahren nach Anspruch 5, dadurch gekennzeichnet, daß der Grenzwertspeicher durch einen Rücksetzimpuls wahlweise oder selbsttätig gelöscht wird.

7. Verfahren nach Anspruch 1 oder folgenden, dadurch gekennzeichnet, daß bei Verwendung eines Farbbildschirmgerätes die die Torschaltung passierenden Impulse einer Auswahlschaltung zugeführt werden, die den Farbkanälen eines Farbbildgerätes zugeordnete R-, G-, B-Ausgänge aufweist und dem Grenzwert (tGW) bzw. Meßwert (tx) entsprechenden Ausgängen Ausgangssignale in Abhängigkeit von der Größe des Grenzwertes und/oder des Meßwertes abgibt und die R-, G-, B-Signale dem Sichtgerät direkt oder als F-BAS-Signale umgewandelt oder über eine HF-Stufe als norminiertes HF-Farbsignal zugeleitet werden.

8. Verfahren nach Anspruch 1 oder folgenden, dadurch gekennzeichnet, daß zur gleichzeitigen Darstellung mehrerer Grenzwerte und/oder Meßwerte jedem Meßwert ein Meßwertkanal und diesem eine Torschaltung zugeordnet ist, daß der Torschaltung eines ersten Meßwertkanales ein in einer Torzeitstufe mittels Monoflop und/oder Flipflop gebildeter bild- oder zeilensynchroner Torzeitimpuls zugeleitet wird, und daß die den einzelnen Meßsignalen (txi) zugeordneten Torzeitimpulse zeitlich nacheinander der jeweils nachfolgenden Torzeitstufe des nächsten Meßkanales zugeführt werden.

9. Verfahren nach Anspruch 8, dadurch gekennzeichnet, daß die Gesamtzeit eines bzw. aller Torzeitimpulse gleich oder kleiner ist als die Zeitdauer einer Zeile auf dem Bildschirm des Sichtgerätes.

10. Verfahren nach Anspruch 8, dadurch gekennzeichnet, daß die Gesamtzeit eines bzw. aller Torzeitimpulse gleich oder kleiner ist als die Zeitdauer eines Bildes auf dem Sichtgerät.

11. Anordnung zum vertikalen oder horizontalen Darstellen eines oder mehrerer Meßwerte beliebiger Meßgrößen auf dem Bildschirm eines nach dem Zeilenrasterverfahren arbeitenden Sichtgerätes, insbesondere eines Farbbildschirmgerätes, bei dem in einem Synchronimpulsgenerator Zeilen- und Bildfrequenzimpulse erzeugt werden, insbesondere zum Durchführen eines der Verfahren nach den Ansprüchen 1 bis 10, mit einem Netzteil und einem Synchronimpulsgenerator, gekennzeichnet durch eine den Synchronimpulsgenerator (2), eine Videopegelanpassungsstufe (8) und eine Synchronmischstufe (9) enthaltende Grundeinheit (1) und mindestens eine Meßkanaleinheit (4), in der ein eine Meßspannung (Ux) normierender Meßspannungsverstärker (11) angeordnet ist, sowie ein Addierverstärker (12), dem einerseits die Meßspannung (Ux) und andererseits eine von einem Sägezahngenerator (3) erzeugte sägezahnartige Spannung (Us) über einen Entkopplungsverstärker (25) zugeführt werden, wobei für die Meßwertabbildung auf dem Bildschirm von unten nach oben bei vertikaler Darstellung bzw. von rechts nach links bei horizontaler Darstellung eine Sägezahnspannung (Us) mit ansteigender Flanke oder für die Abbildung von oben nach unten bei vertikaler Darstellung bzw. von links nach rechts bei horizontaler Darstellung eine Sägezahnspannung mit abfallender Flanke benutzt wird, ferner ein Schwellwertschalter (13), dem die Summenspannung des Addierverstärkers (12) zugeführt wird, und eine ein Ausgangssignal (tx) des Schwellwertschalters (13) mit dem Zeilen- oder Bildfrequenzimpuls (fsynH, fsynV) synchronisierten Torschaltung (14), die an eine Videopegelanpassungsstufe (8) ein dem Meßwert proportionales Meßwertsignal liefert, aus dem in der folgenden Synchronimpulsmischstufe (9) ein Videosignal (BAS) gebildet wird.

12. Anordnung nach Anspruch 11, dadurch gekennzeichnet, daß die Torschaltung (14) ein UND-Gatter (20), ein NAND-Gatter oder eine 3-state-Schaltung (38) ist.

13. Anordnung nach Anspruch 11 oder 12, gekennzeichnet durch einen Grenzwertgeber (18), dem von einer einstellbaren Festspannungsquelle (19) über einen ersten Verstärker (11) eine Grenzwertspannung (Ug) zugeführt wird und der einen Addierverstärker (12) zur Bildung einer Summenspannung aus der Grenzwertspannung und einer sägezahnartigen, von einem Sägezahngenerator erzeugten Spannung (Us) enthält, wobei dem Addierverstärker (12) ein Schwellwertschalter (13) nachgeschaltet ist, dessen Ausgang mit der Torschaltung verbunden ist.

14. Anordnung nach Anspruch 11 oder folgenden, dadurch gekennzeichnet, daß in jeder Meßkanaleinheit (4) mindestens ein Grenzwertgeber (18) vorgesehen ist.

15. Anordnung nach Anspruch 11 oder folgenden, gekennzeichnet durch eine Flip-Flop-Schaltung (21), die durch einen Synchronimpuls gesetzt und nach der Zeit (tx) zurückgesetzt wird, zur Erzeugung eines meßwertproportionalen, im gesetzten Zustand von der Meßspannung unabhängigen Meßsignales.

16. Anordnung nach einem der Ansprüche 11 bis 14, gekennzeichnet durch eine von Synchronimpulsen (fsynV oder fsynH) gestartete Monoflopstufe (23), wobei der zeitbestimmende Widerstand (R) des RC-Gliedes eine von der Meßspannung (Ux) gesteuerte Konstantstromquelle (22) ist.

17. Anordnung nach Anspruch 16, dadurch gekennzeichnet, daß zur Erzeugung eines Meßsignales (tx) und eines Grenzwertsignales (tGW) der Widerstand des RC-Gliedes des Monoflops (23) als willkürlich oder vom Meßwert verstellbares Potentiometer (19) ausgebildet ist.

18. Anordnung nach Anspruch 13 oder folgenden, dadurch gekennzeichnet, daß allen Grenzwertgebern (18) und allen Meßwertgebern (28) ein gemeinsamer Sägezahngenerator (3) zugeordnet ist und daß in jedem Grenzwertgeber (18) und in jeder Meßwertgeberstufe (28) ein Entkoppelungsverstärker (25) vorgesehen ist und als Operationsverstärker zur Linearisierung des Meßwertes (Ux) dient.

19. Anordnung nach Anspruch 11 oder folgenden, dadurch gekennzeichnet, daß der Sägezahngenerator als Treppengenerator (26) ausgebildet ist.

20. Anordnung nach Anspruch 11 oder folgenden, dadurch gekennzeichnet, daß in jedem Meßkanal (4) mit Grenzwertgeber (18) ein Grenzwertmarkengeber (31) mit dem Grenzwertgeber (18) und der Torschaltung (14) verkoppelt sind und daß zur Verhinderung von Fehlfunktionen in der nachfolgenden Schaltung ein ODER- bzw. ein Diodengatter (30) vorgesehen ist.

21. Anordnung nach Anspruch 11 oder folgenden, gekennzeichnet durch eine der (oder den) Torschaltung(en) (14) nachgeschaltete Auswahlschaltung (7) mit NAND-Gattern und Inverterstufen.

22. Anordnung nach Anspruch 14 oder folgenden, gekennzeichnet durch jedem Grenzwertgeber (18) zugeordnete Grenzwertspeicher (32, FF1, FF2).

23. Anordnung nach Anspruch 22, dadurch gekennzeichnet, daß die Grenzwertspeicher (32) als Flip-Flop-Schaltung ausgebildet sind, die bei Erreichen oder Überschreiten des Grenzwertes durch den Meßwert gesetzt und wahlweise einzeln von Hand oder impulsgesteuert zurückgesetzt werden.

24. Anordnung nach Anspruch 11 oder folgenden, gekennzeichnet durch eine Torzeitstufe (34) zur zeitlichen Begrenzung der Darstellung des Meßwertes und der Grenzwerte auf dem Bildschirm (16) eines angeschlossenen Bildschirmgerätes (15) auf einen Teil eines Zeilenablaufes, wobei die Torzeitstufe (34) einen vom Zeilenimpuls (fsynH) gestarteten Monoflop aufweist, dessen Laufzeit $\leq$ der Zeilendauer ist.

25. Anordnung nach Anspruch 11 oder folgenden, dadurch gekennzeichnet, daß zur gemeinsamen Darstellung mehrerer Meßwerte auf dem Bildschirm (16) des Sichtgerätes (15) je Meßwert eine Meßkanaleinheit (4) vorgesehen ist, mit einer Torzeitstufe (34), die die jeweilige Torschaltung (14) steuert und nach Ablauf der Torzeit (29) einen Startimpuls (Si) an die nachfolgende Meßkanaleinheit (4b) abgibt.

26. Anordnung nach Anspruch 24 oder 25, dadurch gekennzeichnet, daß die Torzeitstufe (34) eines ersten Meßkanales (4a) von einer Torzeitzentrale (35) gestartet wird und nach Ablauf ihrer Torzeit einen Startimpuls (Si) an die Torzeitstufe (34) des nachfolgenden Meßkanales (4b usw.) und an die Torzeitzentrale (35) abgibt.

27. Anordnung nach Anspruch 11 oder folgenden, dadurch gekennzeichnet, daß die Grundeinheit (1) und die Meßkanaleinheiten (4) einerseits über einen DatenBUS (6), dem von den Meßkanaleinheiten (4) die Meßwerte, Grenzwerte, Grenzwertimpulse und dergleichen zugeführt und von diesem an die Grundeinheit (1) geleitet werden, und andererseits über einen SteuerBUS (5) verbunden sind, dem von der Grundeinheit (1) die Synchronimpulse (fsynH, fsynV), gegebenenfalls die Sägezahnspannung (Us) und die Torzeitimpulse, zur Abgabe an die Meßwertkanäle (4) zugeführt werden.

28. Anordnung nach Anspruch 27, dadurch gekennzeichnet, daß bei Verwendung eines Farbbildschirmsichtgerätes dem DatenBUS (6) von der Auswahlschaltung (7) die R-, G-, und B-Signale zugeführt werden.

29. Anordnung nach Anspruch 11 oder folgenden, gekennzeichnet durch eine Datenschnittstelle (60) zur Verbindung der Anordnung mit einer Datenverarbeitungseinheit.

30. Anordnung nach Anspruch 11 oder folgenden, gekennzeichnet durch eine Schaltstufe (58) zur Erzeugung von festen und/oder variablen Skalierungslinien auf dem Bildschirm (16) des Sichtgerätes (15).

31. Anordnung nach Anspruch 11 oder folgenden, gekennzeichnet durch einen wahlweise betätigbaren Schriftgenerator (55).

32. Anordnung nach Anspruch 11 oder folgenden, gekennzeichnet durch eine Schaltungseinheit (57) zur wahlweisen Einblendung von Uhrzeit und/oder Datum auf dem Bildschirm (16) des Sichtgerätes (15).

**Claims**

1. Method for the vertical or horizontal representation of one or a plurality of measured values of any desired variables on the screen of a display unit operating according to the line scanning method, particularly a colour video terminal, wherein line and frame frequency pulses are generated in a synchronizing pulse generator, characterised in that a measuring voltage (Ux) corresponding to each measurable variable is formed and first standardized in a measuring voltage amplifier (V1) and then fed to a summing amplifier (12) to which, at the same time, a voltage (Us) of sawtooth form is fed, that the voltage (Us) of sawtooth form is synchronized by the frame or line frequency pulses (fsynV or fsynH) or by a frequency corresponding to the frame or line frequency pulses and the output voltage of the summing amplifier is fed to a threshold switch which, when the threshold is exceeded by the total voltage, transmits a signal (tx) proportional in time to the measuring voltage, a ramp voltage (Us) having a pulse leading-edge being used to form measured values on the screen from the bottom to the top of the screen in the case of vertical representation, or from the right to the left of the screen in the case of horizontal representation, or a ramp voltage having a pulse trailing-edge being used to form measured values from the top to the bottom of the screen in the case of vertical representation or from the left to the right of the screen in the case of horizontal representation, and that the signal (tx) which is proportional to the measuring voltage is transmitted to a following gate circuit (14) synchronized with the line or frame frequency pulses (fsynH or fsynV) and, after level adjustment and the mixing of synchronizing pulses, is transmitted as a video signal (image, blanking and synchronizing signal) to the display unit.

2. Method according to Claim 1, characterised in that a limiting value signal is also transmitted to the gate circuit (14), which signal is transmitted by the feeding of a controllable fixed voltage (Ug) to a summing amplifier to which, on the other hand, a voltage (Us) of sawtooth form is fed and synchronized by the frame or line synchronizing pulse (fsynV, fsynH), and, similarly to the measuring signal generated by a threshold switch, generates a limiting value signal (tGW) proportional in time to the limiting value.

3. Method according to Claim 2, characterised in that the voltage (Us) of sawtooth form for creating the measured value signal (tx) and creating the limiting value (tGW) are created by a common sawtooth generator.

4. Method according to Claim 2 or 3, characterised in that, to form a limiting value mark on the screen of the display unit when there is no measuring voltage or when a measuring voltage is less than the limiting value, a limiting value mark signal (tGWM) wich is proportional in time to the limiting value mark is generated and transmitted to the measured value signal (tx) and to the gate circuit.

5. Method according to Claim 4, characterised in that when a preset limiting value is exceeded, a limiting value memory is activated by the measuring signal (tx).

6. Method according to Claim 5, characterised in that the limiting value memory is selectively or automatically deleted by a reset pulse.

7. Method according to Claim 1 or following claims, characterised in that when using a colour video terminal, the pulses passing through the gate circuit are transmitted to a selector circuit which has R, G and B outputs associated with the colour channels of a colour video terminal and transmits output signals depending on the quantity of the limiting value and/or of the measured value to outputs corresponding to the limiting value (tGW) or measured value (tx), and the R, G and B signals are transmitted to the display unit either directly or as converted composite colour signals or as a standardized high-frequency colour signal via a high-frequency stage.

8. Method according to Claim 1 or following claims, characterised in that a measured value channel is associated with each measured value and a gate circuit is associated with each of these channels for the simultaneous display of a plurality of limiting values and/or measured values, that a frame or line-synchronizing gate time pulse, which is formed in a gate time unit by means of a monostable multivibrator and/or a flip-flop, is transmitted to the gate circuit of a first measured value channel, and that the gate time pulses associated with the individual measuring signals (txi) are fed successively in time to each following gate time unit of the next measuring channel.

9. Method according to Claim 8, characterised in that the total time of one or all of the gate time pulses is equal to or less than the duration of a line on the screen of the display unit.

10. Method according to Claim 8, characterised in that the total time of one or all of the gate time pulses is equal to or less thant the duration of a picture on the display unit.

11. Arrangement for the vertical or horizontal representation of one or a plurality of measured values of any desired variables on the screen of a display unit operating according to the line scanning method, particularly a colour video terminal, wherein line and frame frequency pulses are generated in a synchronizing pulse generator, particularly for carrying out one of the methods according to Claims 1 to 10, having a power pack and a synchronizing pulse generator, characterised by a basic unit (1), which contains the synchronizing pulse generator (2), a video signal level adjusting unit (8) and a synchronous mixing unit (9), and by at least one measuring channel unit (4) in which there is arranged a measuring voltage amplifier (11) for standardizing a measuring voltage (Ux), and a summing amplifier (12) to which, on the one hand, the measuring voltage (Ux) and, on the other hand, a voltage (Us) of sawtooth form generated by a sawtooth generator (3) are fed via a decoupling amplifier (25), a ramp voltage (Us) having a pulse leading-edge being used to display measured values on the screen from the bottom to the top of the screen in the case of vertical representation or from the right to the left of the screen in the case of horizontal representation, or a ramp voltage having a pulse trailing-edge being used to display measured values from the top to the bottom of the screen in the case of vertical representation or from the left to the right of the screen in the case of horizontal representation, and also a threshold switch (13) to which the total voltage of the summing amplifier (12) is fed, and a gate circuit (14) which is synchronized with the line or frame frequency pulse (fsynH, fsynV) by an output signal (tx) of the threshold switch (13) and which delivers to a video signal level adjusting unit (8) a measured value signal which is proportional to the measured value and from which a video signal (image, blanking and synchronizing signal) is formed in the following synchronizing pulse mixing unit (9).

12. Arrangement according to Claim 11, characterised in that the gate circuit (14) is an AND gate (20), a NAND gate or a three-state circuit (38).

13. Arrangement according to Claim 11 or 12, characterised by a limiting value transmitter (18) to which a limiting value voltage (Ug) is fed by a controllable fixed voltage source (19) via a first amplifier (11) and which contains a summing amplifier (12) to form a total voltage from the limiting value voltage and a voltage (Us) of sawtooth form generated by a sawtooth generator, the summing amplifier (12) being followed in the circuit by a threshold switch (13), the output of which is connected to the gate circuit.

14. Arrangement according to Claim 11 or following claims, characterised in that at least one limiting value transmitter (18) is provided in each measuring channel unit (4).

15. Arrangement according to Claim 11 or following claims, characterised by a flip-flop circuit (21) which is set by a synchronizing pulse and reset after time (tx) to generate a measuring signal which is proportional to the measured value and which, when in the set state, is independent from the measuring voltage.

16. Arrangement according to any one of Claims 11 to 14, characterised by a monostable multivibrator stage (23) which is started by synchronizing pulses (fsynV or fsynH), the time determining resistance (R) of the RC-network being a stabilized power source (22) controlled by the measuring voltage (Ux).

17. Arrangement according to Claim 16, characterised in that, to generate a measuring signal (tx) and a limiting value signal (tGW), the resistance of the RC-network of the monostable multivibrator (23) is designed in the form of a potentiometer (19) which can be adjusted at random or by the measured value.

18. Arrangement according to Claim 13 or following claims, characterised in that all the limiting value transmitters (18) and all the measurement transducers (28) are associated with a common sawtooth generator (3), and that a decoupling amplifier (25) is provided in each limiting value transmitter (18) and in each measurement transducer stage (28) and serves as an operational amplifier to linearize the measured value.

19. Arrangement according to Claim 11 or following claims, characterised in that the sawtooth generator is in the form of a staircase-type voltage generator (26).

20. Arrangement according to Claim 11 or following claims, characterised in that in each measuring channel (4) having a limiting value transmitter (18), a limiting value mark transmitter (31) is coupled with the limiting value transmitter (18) and the gate circuit (14), and that an OR gate or a diode gate (30) is provided to prevent malfunctions in the following circuit.

21. Arrangement according to Claim 11 or following claims, characterised by a selector circuit (7) which is arranged after the gate circuit (or circuits) (14) and which has NAND gates and inverter stages.

22. Arrangement according to Claim 14 or following claims, characterised by limiting value memories (32, FF1, FF2) associated with each limiting value transducer (18).

23. Arrangement according to Claim 22, characterised in that the limiting value memories (32) are in the form of a flip-flop circuit which, when the limiting value is reached or exceeded, is set by the measured value, and selectively reset individually by hand or with pulse control.

24. Arrangement according to Claim 11 or following claims, characterised by a gate time unit (34) for limiting the display time of the measured value and limiting values on the screen (16) of a connected video terminal (15) to part of a line run, the gate time unit (34) having a monostable multivibrator which is activated by the line pulse (fsynH) and the operating time of which is ≤ the line duration.

25. Arrangement according to Claim 11 or following claims, characterised in that for the joint display of a plurality of measured values on the screen (16) of the display unit (15), a measuring channel unit (4) is provided for each measured value, with a gate time unit (34) which controls each gate circuit (14) and, after expiry of the gate time (29), transmits an activating pulse (Si) to the following measuring channel unit (4b).

26. Arrangement according to Claim 24 or 25, characterised in that the gate time unit (34) of a first measuring channel (4a) is activated by a gate time control unit (35) and, after the expiry of its gate time, transmits an activating pulse (Si) to the gate time unit (34) of the following measuring channel (4b, etc.) and to the gate time control unit (35).

27. Arrangement according to Claim 11 or following claims, characterised in that the basic unit (1) and the measuring channel units (4) are connected, on the one hand, via a data bus (6) to which the measured values, limiting values, limiting value pulses and the like are fed by the measuring channel units (4) and transmitted from these units to the basic unit (1) and, on the other hand, via a control bus (5) to which the synchronising pulses (fsynH, fsynV), if necessary the ramp voltage (Us) and the gate time pulses, are fed by the basic unit to be transmitted to the measured value channels (4).

28. Arrangement according to Claim 27, characterised in that, when a colour video terminal is used, the R, G and B signals are transmitted to the data bus (6) by the selector circuit (7).

29. Arrangement according to Claim 11 or following claims, characterised by a data interface (60) for connecting the arrangement to a data processing unit.

30. Arrangement according to Claim 11 or following claims, characterised by a control stage (58) for producing fixed and/or variable scaling lines on the screen (16) of the display unit (15).

31. Arrangement according to Claim 11 or following claims, characterised by a caption generator (55) which can be operated selectively.

32. Arrangement according to Claim 11 or following claims, characterised by a circuit element (57) for the selective superimposition of clock time and/or date on the screen (16) of the display unit (15).

## Revendications

1. Procédé pour la représentation verticale ou horizontale d'une ou plusieurs valeurs mesurées de grandeurs mesurées quelconques sur l'écran d'un poste de visualisation travaillant suivant le procédé à trame de lignes, notamment d'un poste à écran couleur, dans lequel on produit des impulsions de fréquence de lignes et d'image dans un générateur d'impulsions de synchronisation, caractérisé en ce qu'on élabore une tension de mesure (Ux) correspondant à chaque grandeur mesurée et on la normalise tout d'abord dans un amplificateur de tension de mesure (V1), puis on l'envoie sur un amplificateur d'addition (12) auquel on envoie simultanément une tension évoluant en dents de scie (Us), en ce qu'on synchronise la tension en dents de scie (Us) par les impulsions de fréquence d'image ou de lignes (fsynV ou fsynH) ou par une fréquence correspondant aux impulsions de fréquence d'image ou de lignes et on envoie la tension de sortie de l'amplificateur d'addition sur un circuit à seuil qui, lors du franchissement du seuil par la tension-somme, délivre un signal (tx) proportionnel dans le temps à la tension de mesure, une tension en dents de scie (Us) à flanc montant étant utilisée pour la visualisation de la valeur mesurée sur l'écran de bas en haut dans le cas d'une représentation verticale ou de droite à gauche dans le cas d'une représentation horizontale ou bien une tension en dents de scie à flanc tombant étant utilisée pour la visualisation de haut en bas dans le cas d'une représentation verticale ou de gauche à droite dans le cas d'une représentation horizontale, et en ce qu'on envoie le signal (tx) proportionnel à la tension de mesure à un circuit porte (14) placé en aval et synchronisé avec les impulsions de fréquence de lignes ou d'image (fsynH ou fsynV) et, après adaptation de niveau et mélange d'impulsion de synchronisation, on l'envoie, en tant que signal vidéo (signal-BAS) au poste de visualisation.

2. Procédé selon la revendication 1, caractérisé en ce qu'on envoie en plus au circuit porte (14) un signal de valeur limite qui, par envoi d'une tension fixe réglable (Ug) sur un amplificateur d'addition auquel on envoie d'autre part une tension en dents de scie (Us) qui est synchronisée par l'impulsion de synchronisation d'image ou de lignes (fsynV, fsynH), et, d'une manière analogue à la production du signal de mesure, par l'intermédiaire d'un circuit à seuil, produit un signal de valeur limite (tGW) proportionnel dans le temps à la valeur limite.

3. Procédé selon la revendication 2, caractérisé en ce qu'on élabore la tension en dents de scie (Us) pour l'élaboration du signal de valeur mesurée (tx) et l'élaboration de la valeur limite (tGW) à l'aide d'un générateur en dents de scie commun.

4. Procédé selon la revendication 2 ou 3, caractérisé en ce que, pour la visualisation d'un repère de valeur limite sur l'écran du poste de visualisation en l'absence de tension de mesure ou dans le cas d'une tension de mesure plus petite que la valeur limite, on produit un signal de repère de valeur limite (tGWM) proportionnel dans le temps au repère de valeur limite et on l'envoie au signal de valeur mesurée (tx) et au circuit porte.

5. Procédé selon la revendication 4, caractérisé en ce que, en cas de franchissement d'une valeur limite préfixée de la part du signal de mesure (tx), une mémoire de valeur limite se trouve activée.

6. Procédé selon la revendication 5, caractérisé en ce que la mémoire de valeur limite se trouve remise à zéro automatiquement ou à la commande à l'aide d'une impulsion de remise à l'état initial.

7. Procédé selon la revendication 1 ou suivantes, caractérisé en ce que, dans le cas d'utilisation d'un poste à écran couleur, on envoie les impulsions qui traversent le circuit porte sur un circuit de sélection qui comporte des sorties -R, -G, -B associées aux canaux de couleurs d'un poste couleur et qui, en fonction de la grandeur de la valeur limite et/ou de la valeur mesurée, délivre des signaux de sortie aux sorties correspondant à la valeur limite (tGW) ou à la valeur mesurée (tx), et en ce qu'on envoie les signaux -R, -G, -B au poste de visualisation directement ou transformés en signaux F-BAS ou, par l'intermédiaire d'un étage HF, en tant que signal couleur HF normalisé.

8. Procédé selon la revendication 1 ou suivantes, caractérisé en ce que, pour la représentation simultanée de plusieurs valeurs limites et/ou valeurs mesurées, on associe à chaque valeur mesurée un canal de valeur mesurée et à celui-ci un circuit porte, en ce qu'on envoie au circuit porte d'un premier canal de valeur mesurée une impulsion de temps de déclenchement synchrone en image ou en ligne et élaborée dans un étage de temps de déclenchement au moyen d'une bascule monostable et/ou d'une bascule bistable, et en ce qu'on envoie les impulsions de temps de déclenchement associées aux signaux mesurés individuels (txi), l'une derrière l'autre dans le temps, à l'étage de temps de déclenchement, à chaque fois placé en aval, du canal de mesure suivant.

9. Procédé selon la revendication 8, caractérisé en ce que le temps total d'une ou de toutes les impulsions de temps de déclenchement est égal ou inférieur à la durée d'une ligne sur l'écran du poste de visualisation.

10. Procédé selon la revendication 8, caractérisé en ce que le temps total d'une ou de toutes les impulsions de temps de déclenchement est égal ou inférieur à la durée d'une image sur le poste de visualisation.

11. Dispositif pour la représentation verticale ou horizontale d'une ou plusieurs valeurs mesurées de grandeurs mesurées quelconques sur l'écran d'un poste de visualisation travaillant suivant le procédé à trame de lignes, notamment d'un poste à écran couleur, dans lequel on produit des impulsions de fréquence de lignes et d'image dans un générateur d'impulsions de synchronisation, notamment pour la mise en œuvre de l'un des procédés selon les revendications 1 à 10, comportant une alimentation secteur et un générateur d'impulsions de synchronisation, caractérisé par une unité de base (1) contenant le générateur d'impulsions de synchronisation (2), un étage d'adaptation de niveau vidéo (8) et un étage de mélange de synchronisation (9) et par au moins une unité de canal de mesure (4) dans lequel est disposé un amplificateur de tension de mesure (11) normalisant une tension de mesure (Ux), ainsi que par un amplificateur d'addition (12) auquel sont envoyées d'une part la tension de mesure (Ux) et d'autre part, en passant par un amplificateur de découplage (25), une tension en dents de scie (Us) produite par un générateur en dents de scie (3), une tension en dents de scie (Us) à flanc montant étant utilisée pour la visualisation de la valeur mesurée sur l'écran de bas en haut dans le cas d'une représentation verticale ou de droite à gauche dans le cas d'une représentation horizontale ou bien une tension en dents de scie à flanc tombant étant utilisée pour la visualisation de haut en bas dans le cas d'une représentation verticale ou de gauche à droite dans le cas d'une représentation horizontale, en outre par un circuit à seuil (13) auquel on envoie la tension-somme de l'amplificateur d'addition (12), et par un circuit porte (14), synchronisant un signal de sortie (tx) du circuit à seuil (13) avec l'impulsion de fréquence de lignes ou d'image (fsynH, fsynV), qui délivre à un étage d'adaptation de niveau vidéo (8) un signal de valeur mesurée proportionnel à la valeur mesurée et à partir duquel on élabore un signal vidéo (BAS) dans l'étage suivant de mélange d'impulsion de synchronisation (9).

12. Dispositif selon la revendication 11, caractérisé en ce que le circuit porte (14) est une porte ET (20), une porte NON-ET ou un circuit à 3 états (38).

13. Dispositif selon la revendication 11 ou 12, caractérisé par un émetteur de valeur limite (18) auquel une tension de valeur limite (Ug) est envoyée à partir d'une source de tension constante réglable (19) par l'intermédiaire d'un premier amplificateur (11) et qui contient un amplificateur d'addition (12) pour l'élaboration d'une tension-somme à partir de la tension de valeur limite et d'une tension en dents de scie (Us) produite par un générateur en dents de scie, un circuit à seuil (13), dont la sortie est reliée au circuit porte, étant placé en aval de l'amplificateur d'addition (12).

14. Dispositif selon la revendication 11 ou suivantes, caractérisé en ce que, dans chaque unité de canal de mesure (4), il est prévu au moins un émetteur de valeur limite (18).

15. Dispositif selon la revendication 11 ou suivantes, caractérisé par un circuit bistable (21) qui est mis à un à l'aide d'une impulsion de synchronisation et remis à zéro après le temps (tx), en vue de la production d'un signal de mesure proportionnel à la valeur de mesure et indépendant, lorsqu'il est mis à un, de la tension de mesure.

16. Dispositif selon l'une des revendications 11 à 14, caractérisé par un étage monostable (23) déclenché par des impulsions de synchronisation (fsynV ou fsynH), la résistance (R) déterminant le temps du circuit RC étant une source à courant constant (22) commandée par la tension de mesure (Ux).

17. Dispositif selon la revendication 16, caractérisé en ce que, pour la production d'un signal de mesure (tx) et d'un signal de valeur limite (tGW), la résistance du circuit RC de la bascule monostable (23) est agencée sous la forme d'un potentiomètre (19) réglable à la commande ou par la valeur mesurée.

18. Dispositif selon la revendication 13 ou suivantes, caractérisé en ce qu'un générateur de dents de scie (3) commun est associé à tous les émetteurs de valeur limite (18) et à tous les émetteurs de valeur mesurée (28) et en ce qu'un amplificateur de découplage (25) est prévu dans chaque émetteur de valeur limite (18) et dans chaque étage émetteur de valeur mesurée (28) et sert d'amplificateur opérationnel pour la correction de linéarité de la valeur mesurée (Ux).

19. Dispositif selon la revendication 11 ou suivantes, caractérisé en ce que le générateur en dents de scie est agencé sous la forme d'un générateur en escalier (26).

20. Dispositif selon la revendication 11 ou suivantes, caractérisé en ce que, dans chaque canal de mesure (4) présentant un émetteur de valeur limite (18), un émetteur de repère de valeur limite (31) est accouplé avec l'émetteur de valeur limite (18) et le circuit porte (14), et en ce que, pour empêcher des défauts de fonctionnement dans le circuit placé en aval, il est prévu une porte OU ou à diodes (30).

21. Dispositif selon la revendication 11 ou suivantes, caractérisé par un circuit de sélection (7) placé en aval de la (ou des) circuit(s) porte(s) (14) et comportant des portes NON-ET et des étages inverseurs.

22. Dispositif selon la revendication 14 ou suivantes, caractérisé par des mémoires de valeur limite (32, FF1, FF2) associées à chaque émetteur de valeur limite (18).

23. Dispositif selon la revendication 22, caractérisé en ce que les mémoires de valeur limite (32) sont agencées sous la forme de circuits bistables qui sont mis à un lorsque la valeur mesurée atteint ou franchit la valeur limite et remis à zéro à volonté, individuellement à la main ou par commande par impulsion.

24. Dispositif selon la revendication 11 ou suivantes, caractérisé par un étage de temps de déclenchement (34) pour la limitation dans le temps, à une partie d'un déroulement de ligne, de la représentation de la valeur mesurée et des valeurs limites sur l'écran (16) d'un poste à écran raccordé (15), l'étage de temps de déclenchement (34) comportant une bascule monostable déclenchée par l'impulsion de ligne (fsynH) et dont la durée de fonctionnement est $\leqslant$ à la durée de ligne.

25. Dispositif selon la revendication 11 ou suivantes, caractérisé en ce que, pour la représentation commune de plusieurs valeurs mesurées sur l'écran (16) du poste de visualisation (15), il est prévu pour chaque valeur mesurée une unité de canal de mesure (4), avec un étage de temps de déclenchement (34) qui commande le circuit porte correspondant (14) et, après l'écoulement du temps de déclenchement (29), délivre une impulsion de déclenchement (Si) à l'unité de canal de mesure (4b) placée en aval.

26. Dispositif selon la revendication 24 ou 25, caractérisé en ce que l'étage de temps de déclenchement (34) d'un premier canal de mesure (4a) est déclenché par une centrale de temps de déclenchement (35) et, après l'écoulement de son temps de déclenchement, délivre une impulsion de déclenchement (Si) à l'étage de temps de déclenchement (34) du canal de mesure placé en aval (4b etc.) et à la centrale de temps de déclenchement (35).

27. Dispositif selon la revendication 11 ou suivantes, caractérisé en ce que l'unité de base (1) et les unités de canal de mesure (4) sont reliées d'une part par l'intermédiaire d'un BUS de données (6) auquel sont amenées, à partir des unités de canal de mesure (4), les valeurs mesurées, les valeurs limite, les impulsions de valeurs limite et analogues et à partir duquel elles sont conduites à l'unité de base (1), et d'autre part par l'intermédiaire d'un BUS de commande (5) auquel sont envoyées, à partir de l'unité de base (1), les impulsions de synchronisation (fsynH, fsynV), éventuellement la tension en dents de scie (Us) et les impulsions de temps de déclenchement, en vue d'une délivrance aux canaux de valeurs mesurées (4).

28. Dispositif selon la revendication 27, caractérisé en ce que, lors de l'utilisation d'un poste de visualisation à écran couleur, les signaux -R, -G et -B sont envoyés au BUS de données (6) à partir du circuit de sélection (7).

29. Dispositif selon la revendication 11 ou suivantes, caractérisé par une interface de données (60) pour la jonction du dispositif à une unité de traitement de données.

30. Dispositif selon la revendication 11 ou suivantes, caractérisé par un étage de commutation (58) pour la production de lignes de graduation fixes et/ou variables sur l'écran (16) du poste de visualisation (15).

31. Dispositif selon la revendication 11 ou suivantes, caractérisé par un générateur d'écriture

(55) manœuvrable à la commande.

32. Dispositif selon la revendication 11 ou suivantes, caractérisé par une unité de circuit (57) pour la surimpression à la commande de l'heure et/ou de la date sur l'écran (16) du poste de visualisation (15).

FIG.1

0 081 493

FIG.2

FIG.3

0 081 493

# FIG.4

SIZ — H
V

2

SG

3

Ux — V1

11,17

V2

12

ST

13

TS

14

VPA

8

SMS

9

BAS-Signal
Video-Signal

Zeit tx 30%

100%   0%        0%   100%

100%

30%

Ux  0%

# FIG.5

erster
Zeilenimpuls

letzter
Zeilenimpuls

3

0 081 493

## FIG.5a

15 16

SB    MWB

## FIG.5b

SB    MWB

15  16

## FIG.6

V

H

11

Ux → V1  Ux → V2 → ST → TS → VPA → V4 → BAS-Signal

12    13    14    8    9

fsynH → SG  Us

3

## FIG.6a

MWB

100%

SB

15  16

## FIG.6b

MWB

100%

SB

15  16

4

FIG.7

FIG.8

FIG.9

FIG.10

## FIG.11

0 081 493

FIG.12

FIG.13

FIG.14

FIG.15

8

FIG.16

FIG.17

FIG.18

9

## FIG.19

## FIG.19a

# FIG. 20

# FIG. 21

# FIG.22

# FIG.23

FIG. 24

0 081 493